(19) Europäisches Patentamt
European Patent Office
Office européen des brevets

(11) **EP 3 580 631 B1**

(12) **EUROPEAN PATENT SPECIFICATION**

(45) Date of publication and mention
of the grant of the patent:
**22.05.2024   Bulletin 2024/21**

(21) Application number: **18747190.9**

(22) Date of filing: **07.02.2018**

(51) International Patent Classification (IPC):
*G01R 27/16* (2006.01)    *G05F 1/46* (2006.01)
*H02H 9/04* (2006.01)    *H04W 88/08* (2009.01)
*G05F 1/62* (2006.01)    *H04M 19/00* (2006.01)
*H04W 52/00* (2009.01)    *H04W 52/02* (2009.01)
*G01R 19/25* (2006.01)    *G01R 27/08* (2006.01)
*H02H 7/22* (2006.01)

(52) Cooperative Patent Classification (CPC):
**G01R 27/16; G01R 19/2513; G01R 27/08;
H04M 19/00; H04W 52/00; H04W 52/02;
H04W 88/08;** H02H 7/226; H02H 9/041

(86) International application number:
**PCT/US2018/017276**

(87) International publication number:
**WO 2018/145128 (09.08.2018 Gazette 2018/32)**

(54) **METHODS AND EQUIPMENT FOR REDUCING POWER LOSS IN CELLULAR SYSTEMS**

VERFAHREN UND VORRICHTUNG ZUR REDUZIERUNG DER VERLUSTLEISTUNG IN ZELLULAREN SYSTEMEN

PROCÉDÉS ET MATÉRIEL PERMETTANT DE RÉDUIRE LA PERTE DE PUISSANXE DANS DES SYSTÈMES CELLULAIRES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **08.02.2017   US 201762456428 P**

(43) Date of publication of application:
**18.12.2019   Bulletin 2019/51**

(73) Proprietor: **CommScope Technologies LLC
Claremont, NC 28610 (US)**

(72) Inventors:
• **WINKLER, David
Claremont, NC 28610 (US)**
• **COLEMAN, Daryl A.
Claremont, NC 28610 (US)**

• **BECK, Andrew E.
Claremont, NC 28610 (US)**

(74) Representative: **Meissner Bolte Partnerschaft mbB
Patentanwälte Rechtsanwälte
Postfach 86 06 24
81633 München (DE)**

(56) References cited:
US-A1- 2006 164 108      US-A1- 2006 164 108
US-A1- 2008 172 564      US-A1- 2009 215 492
US-A1- 2010 181 840      US-A1- 2012 269 509
US-A1- 2012 317 426      US-A1- 2015 015 078
US-A1- 2015 234 399      US-B1- 6 813 510

**Description**

CROSS-REFERENCE TO RELATED APPLICATIONS

The present application claims benefit of U.S. Patent Application Serial No. 62/456,428, filed February 8, 2017 and claims priority under 35 U.S.C. § 120 as a continuation-in-part of U.S. Patent Application Serial No. 14/701,904, filed May 1, 2015, which in turn claims priority to a continuation-in-part of U.S. Patent Application Serial No. 14/321,897, filed July 2, 2014, which in turn claims benefit of U.S. Provisional Patent Application Serial No. 61/940,631, filed February 17, 2014.

FIELD OF THE INVENTION

The present invention relates generally to cellular communications systems and, more particularly, to cellular communications power supply systems.

BACKGROUND

Cellular base stations typically include, among other things, a radio, a baseband unit, and one or more antennas. The radio receives digital information and control signals from the baseband unit and modulates this information into a radio frequency ("RF") signal that is transmitted through the antennas. The radio also receives RF signals from the antenna and demodulates these signals and supplies them to the baseband unit. The baseband unit processes demodulated signals received from the radio into a format suitable for transmission over a backhaul communications system. The baseband unit also processes signals received from the backhaul communications system and supplies the processed signals to the radio. A power supply may also be provided that generates suitable direct current ("DC") power signals for powering the baseband unit and the radio. For example, the radio is often powered by a (nominal) 48 Volt DC power supply in cellular systems that are currently in use today. A battery backup is also typically provided to maintain service for a limited period of time during power outages.

In order to increase coverage and signal quality, the antennas in many cellular base stations are located at the top of an antenna tower, which may be, for example, about fifty to two hundred feet tall. Antennas are also routinely mounted on other elevated structures such as, for example, buildings, utility poles and the like. Until fairly recently, the power supply, baseband unit and radio were all located in an equipment enclosure at the bottom of the antenna tower or other elevated structure to provide easy access for maintenance, repair and/or later upgrades to the equipment. Coaxial cable(s) were routed from the equipment enclosure to the top of the antenna tower and were used to carry RF signals between the radios and the antennas.

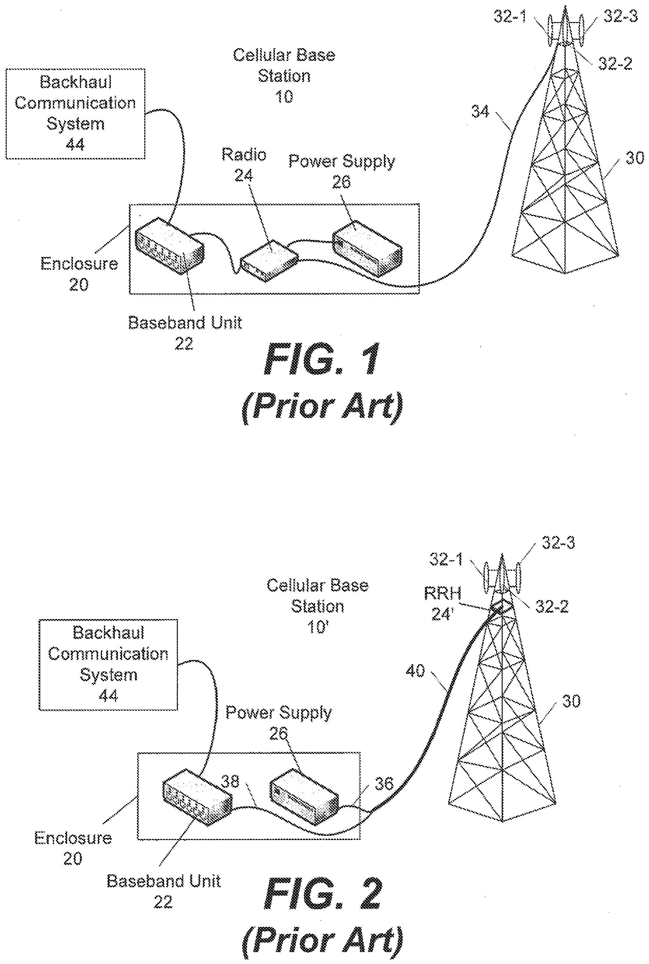

**FIG. 1** is a schematic diagram that illustrates a conventional cellular base station **10**. As shown in **FIG. 1,** the depicted cellular base station **10** includes an equipment enclosure **20** and an antenna tower **30**. The equipment enclosure **20** is typically located at the base of the antenna tower **30,** as shown in **FIG. 1**. A baseband unit **22,** a radio **24** and a power supply **26** are located within the equipment enclosure **20**. The baseband unit **22** may be in communication with a backhaul communications system **44**. A plurality of antennas **32** (e.g., three sectorized antennas **32-1, 32-2, 32-3**) are located at the top of the antenna tower **30**. Three coaxial cables **34** (which are bundled together in **FIG. 1** to appear as a single cable) connect the radio **24** to the antennas **32**. The antennas **32** are passive (unpowered) devices and hence none of the equipment at the top of the tower **30** requires electrical power. While the cellular base station **10** of **FIG. 1** (and various other cellular base stations shown in subsequent figures) is shown as a having a single baseband unit **22** and radio **24** to simplify the drawings and description, it will be appreciated that cellular base stations routinely have multiple baseband units **22** and radios **24** (and additional antennas **32**), with three, six, nine or even twelve baseband units **22** and radios **24** being common in state-of-the-art systems.

In recent years, a shift has occurred and the radio **24** is now more typically located at the top of the tower **30** in new or upgraded cellular installations. Radios that are located at the top of the tower **30** are typically referred to as remote radio heads ("RRH") **24'.** Using remote radio heads **24'** may significantly improve the quality of the cellular data signals that are transmitted and received by the cellular base station, as the use of remote radio heads **24'** may reduce signal transmission losses and noise. In particular, as the coaxial cables **34** that connect radios **24** that are located at the base of an antenna tower **30** to antennas **32** that are mounted near the top of the antenna tower **30** may have lengths of 100-200 feet or more, the signal loss that occurs in transmitting signals at cellular frequencies (e.g., 1.8 GHz, 3.0 GHz, etc.) over these coaxial cables **34** may be significant, as at these frequencies the coaxial cables **34** tend to radiate RF signal energy. Because of this loss in signal power, the signal-to-noise ratio of the RF signals may be degraded in systems that locate the radio **24** at the bottom of the antenna tower **30** as compared to cellular base stations having remote radio heads **24'** that are located at the top of the tower **30** next to the antennas **32** (note that signal losses in the cabling connection between the baseband unit **22** at the bottom of the tower **30** and the remote radio head **24'** at the

EP 3 580 631 B1

top of the tower **30** may be much smaller, as these signals are transmitted at baseband or intermediate frequencies as opposed to RF frequencies, and because these signals may be transmitted up the antenna tower **30** over fiber optic cables, which may exhibit lower losses).

FIG. 2 is a schematic diagram that illustrates a cellular base station **10'** according to this newer architecture. As shown in **FIG. 2,** the baseband unit **22** and the power supply **26** may still be located at the bottom of the tower **30** in the equipment enclosure **20.** The radio **24** in the form of a remote radio head **24'** is located at the top of the tower **30** immediately adjacent to the antennas **32.** While the use of tower-mounted remote radio heads **24'** may improve signal quality, it also, unfortunately, requires that DC power be delivered to the top of the tower **30** to power the remote radio head **24'.** As shown in **FIG. 2,** typically a fiber optic cable **38** connects the baseband unit **22** to the remote radio head **24'** (as fiber optic links may provide greater bandwidth and lower loss transmissions), and a separate or combined ("composite") power cable **36** is provided for delivering the DC power signal to the remote radio head **24'.** The separate power cable **36** is typically bundled with the fiber optic cable **38** so that they may be routed up the tower **30** together. In other cases (not shown), a hybrid fiber optic/power trunk cable **40** may be run up the tower **30.** Such trunk cables **40** typically have junction enclosures on either end thereof, and a first set of data and power jumper cables are used to connect the junction enclosure on the ground end of the trunk cable **40** to the baseband unit(s) **22** and power supply **26,** and a second set of data and power (or combined data/power) jumper cables are used to connect the junction enclosure at the top of the tower **30** to the remote radio heads **24.**

Another change that has occurred in the cellular industry is a rapid increase in the number of subscribers as well as a dramatic increase in the amount of voice and data traffic transmitted and received by a typical subscriber. In response to this change, the number of remote radio heads **24'** and antennas **32** that are being mounted on a typical antenna tower **30** has also increased, with twelve remote radio heads **24'** and twelve or more antennas **32** being a common configuration today. Additionally, higher power remote radio heads **24'** are also being used. These changes may result in increased weight and wind loading on the antenna towers **30** and the need for larger, more expensive trunk cables **40.**

US2015/234399 A1 Is considered relevant and relates to a system for adjusting power provided to a device. The system can include power sourcing equipment and a sub-system. The power sourcing equipment can provide power to a powered device via a channel. The sub-system can determine an amount by which to increase the power based on a resistance of the channel. The power sourcing equipment or the powered device can adjust the power (or load) responsive to a command from the sub-system. The sub-system can include a measurement device and a processor. The measurement device can measure an output voltage of the power sourcing equipment, an input voltage of the powered device, and a current on the channel. The processor can determine the resistance of the channel based on the output voltage, the input voltage, and the current. The processor can output a command specifying an increase or decrease in power supplied by the power sourcing equipment.

US 2012/317426 A1 is considered relevant and discloses a system for adjusting power provided to a device. The system can include power sourcing equipment and a sub-system. The power sourcing equipment can provide power to a powered device via a channel. The sub-system can determine an amount by which to increase the power based on a resistance of the channel. The power sourcing equipment or the powered device can adjust the power (or load) responsive to a command from the sub-system. The sub-system can include a measurement device and a processor. The measurement device can measure an output voltage of the power sourcing equipment, an input voltage of the powered device, and a current on the channel. The processor can determine the resistance of the channel based on the output voltage, the input voltage, and the current. The processor can output a command specifying an increase or decrease in power supplied by the power sourcing equipment.

US 2015/015078 A1 is considered relevant and discloses a cable and a compensation method for transmitting a high speed signal and delivering power. The cable according to one embodiment disclosed in the present specification interconnects a first device and a second device, the cable comprising: a power line for transmitting power from the first device to the second device; and a voltage restorer for restoring voltage loss of the power receiving side of the second device generated based on the voltage drop relevant to the power line."

US 2006/164108 A1 is considered relevant and discloses a system and methodology for determining resistance of wires in a communication cable having at least two pairs of wires used for providing power from a power supply device to a powered device. A measuring mechanism may determine DC resistance of the wires before the power supply device applies power to the communication cable.

US 6 813 510 B1 is considered relevant and discloses a system and method for automatically compensating for transmission line losses at a wireless base station antenna site. Transmission line losses are measured and the result of the measurement is used to adjust a variable gain amplifier which receives reception signals from the transmission line.

3

SUMMARY

0009] According to the invention, the problem is solved by the subject-matter outlined in the independent claims. Advantageous further developments of the invention are set forth in the dependent claims.

BRIEF DESCRIPTION OF THE DRAWINGS

FIG. 1 is a simplified, schematic view of a traditional cellular base station architecture.

FIG. 2 is a simplified, schematic view of a conventional cellular base station in which a remote radio head is located at the top of the antenna tower.

FIG. 3 is a simplified, schematic view of a cellular base station according to embodiments of the present invention.

FIG. 4 is a schematic block diagram of a programmable power supply according to embodiments of the present invention.

FIG. 5 is a schematic block diagram of a programmable power supply according to further embodiments of the present invention.

FIG. 6 is a simplified, schematic view of a cellular base station according to still further embodiments of the present invention.

FIG. 7 is a simplified, schematic view of a cellular base station according to yet additional embodiments of the present invention.

FIG. 8 is a simplified, schematic view of a cellular base station according to yet further embodiments of the present invention.

FIG. 9 is a flow chart illustrating operations of methods according to embodiments of the present invention.

FIG. 10 is a perspective view of an end portion of a hybrid power/fiber optic cable that may be used in cellular base stations according to embodiments of the present invention.

FIG. 11 is a schematic drawing illustrating how a jumper cable that includes a shunt capacitance unit may be used to connect a junction enclosure to a remote radio head in cellular base stations according to embodiments of the present invention.

FIG. 12 is a partially-exploded perspective view of a shunt capacitance unit according to certain embodiments of the present invention.

FIG. 13 is a circuit diagram of a shunt capacitance unit that includes an avalanche diode according to embodiments of the present invention.

FIG. 14 is a circuit diagram of a shunt capacitance unit that includes an avalanche diode according to further embodiments of the present invention.

FIG. 15 is a schematic diagram of a cellular base station according to still further embodiments of the present invention.

FIG. 16 is a simplified, block diagram of a programmable power supply according to yet further embodiments of the present invention.

FIG. 17A is a simplified, schematic view of a cellular base station according to yet further embodiments of the present invention.

FIG. 17B is a simplified, block diagram of a control module according to yet further embodiments of the present invention.

FIG. 17C is a simplified, schematic diagram of a bypass circuit according to yet further embodiments of the present invention.

FIG. 18 is a simplified block diagram of a processing system according to yet further embodiments of the present invention.

FIG. 19 is a flow chart illustrating operations of methods of determining the resistance of the power cable according to yet further embodiments of the present invention.

FIG. 20 is a flow chart illustrating operations of time correlation methods of determining the resistance of the power cable according to yet further embodiments of the present invention.

FIG. 21A is a flow chart illustrating operations of iterative methods of determining the resistance of the power cable according to embodiments of the present invention.

Fig. 21B is a flow chart illustrating operations of methods of determining if the current level is greater than a threshold current according to yet further embodiments of the present invention.

FIG. 22 is a flow chart illustrating operations of bypass methods of determining the resistance of the power cable according to yet further embodiments of the present invention.

DETAILED DESCRIPTION

Pursuant to embodiments of the present invention, methods for delivering DC power to a remote radio head ("RRH") of a cellular base station are provided, along with related cellular base stations, programmable power supplies, power cables and other equipment. These methods, systems, power supplies, cables and equipment may allow for lower power supply currents, which may reduce the power loss associated with delivering the DC power signal from the power supply at the base of a tower of the cellular base station to the remote radio head at the top of the tower. Since cellular towers may be hundreds of feet tall and the voltage and currents required to power each remote radio head may be quite high (e.g., about 50 Volts at about 20 Amperes of current), the power loss that may occur along the hundreds of feet of cabling may be significant. Thus, the methods according to embodiments of the present invention may provide significant power savings which may reduce the costs of operating a cellular base station. Additionally, since the cellular base stations may use less power, the cellular base stations according to embodiments of the present invention may require fewer back-up batteries while maintaining operation for the same period of time during a power outage. This reduction in the amount of back-up batteries may represent a significant additional cost savings.

The DC voltage of a power signal that is supplied to a remote radio head from a power supply over a power cable may be determined as follows:

$$V_{RRH} = V_{PS} - V_{Drop} \tag{1}$$

where $V_{RRH}$ is the DC voltage of the power signal delivered to the remote radio head, $V_{PS}$ is the DC voltage of the power signal that is output by the power supply, and $V_{Drop}$ is the decrease in the DC voltage that occurs as the DC power signal traverses the power cable connecting the power supply to the remote radio head. It will be appreciated that the power cable that connects the power supply to the remote radio head will typically have multiple segments. For example, in cellular base stations in which a trunk cable is used, the power cabling connection will typically include a power jumper cable that connects the power supply to one end of the trunk cable, the power conductors in the trunk cable, and a power jumper cable that connects the other end of the trunk cable to the remote radio head. $V_{Drop}$ in Equation (1) may be determined according to Ohm's Law as follows:

$$V_{Drop} = I_{Cable} * R_{Cable} \tag{2}$$

where $R_{Cable}$ is the cumulative electrical resistance (in Ohms) of the power cable connecting the power supply to the remote radio head and $I_{Cable}$ is the average current (in Amperes) flowing through the power cable to the remote radio head and back to the power supply.

The cumulative electrical resistance $R_{Cable}$ of the power cable is inversely proportional to the diameter of the conductor of the power cable (assuming the conductors have a circular cross-section). Thus, the larger the diameter of each conductor (i.e., the lower the gauge of the conductor), the lower the resistance of the power cable. Typically, power cables utilize copper conductors due to the low resistance of copper. Copper resistance is specified in terms of unit length, typically milliohms (m$\Omega$)/ft; as such, the cumulative electrical resistance $R_{Cable}$ of the power cable increases with the length of the power cable. Thus, the longer the power cable, the higher the voltage drop $V_{Drop}$.

Typically, a minimum required voltage for the power signal, a nominal or recommended voltage for the power signal and a maximum voltage for the power signal will be specified for the remote radio head. Thus, the power supply at the base of the tower must output a voltage $V_{PS}$ such that $V_{RRH}$ will be between the minimum and maximum specified voltages for the power signal of the remote radio head. As $V_{Drop}$ is a function of the current $I_{Cable}$ that is supplied to the remote radio head (see Equation (2) above), if $V_{PS}$ (the voltage output by the power supply) is constant, then the voltage $V_{RRH}$ of the power signal that is delivered to the remote radio head will change with the variation in current $I_{Cable}$ drawn by the remote radio head from the power supply. Conventionally, the voltage output of the power signal by the power supply ($V_{PS}$) is set to ensure that a power signal having the nominal specified voltage is supplied to the remote radio head (or at least a value above the minimum required voltage for the power signal) when the remote radio head draws the maximum anticipated amount of current from the power supply.

The power that is lost ($P_{Loss}$) in delivering the power signal to the remote radio head over a power cable may be calculated as follows:

$$P_{Loss} = V_{Drop} * I_{Cable} = (I_{Cable} * R_{Cable}) * I_{Cable} = I_{Cable}^2 * R_{Cable} \tag{3}$$

In order to reduce or minimize $P_{Loss}$, the power supply may be set to output a DC power signal that, when it arrives at the remote radio head, will have a voltage that is near the maximum voltage specified for the remote radio head, as the higher the voltage of the power signal that is delivered to the remote radio head, the lower the current $I_{Cable}$ of the power signal on the power cable. As is apparent from Equation (3) above, the lower the current $I_{Cable}$ of the power signal on the power cable, the lower the power loss $P_{Loss}$.

Pursuant to embodiments of the present invention, the power supply may comprise a programmable power supply which may (1) sense the current being drawn by the remote radio head (or another equivalent parameter) and (2) adjust the voltage of the power signal that is output by the power supply to substantially maintain the voltage of the power signal that is supplied to the remote radio head at or near a desired value, which may be, for example, the maximum voltage for the power signal that may be input to the remote radio head. In order to accomplish this, the resistance of the power cable may be input to the programmable power supply or, alternatively, other information such as, for example, the length and size of the power cable, or the impedance of the power cable, may be input to the programmable power supply and the programmable power supply may determine the resistance of the power cable from this information. As the current drawn by the remote radio head varies, the programmable power supply may adjust the voltage of its output power signal to a voltage level that will deliver a power signal having a preselected voltage (e.g., the maximum supply voltage of the remote radio head minus a buffer) to the remote radio head. As shown by Equation (3) above, this will reduce the power loss along the power cable, and hence may reduce the cost of powering the remote radio head. As a typical remote radio head may require about a kilowatt of power and may run 24 hours a day, seven days a week, and as a large number of remote radio heads may be provided at each cellular base station (e.g., three to twelve), the power savings may be significant.

Maintaining the preselected voltage closer to the maximum remote radio head input voltage has additional benefits. Firstly, it reduces the risk of the voltage dropping below the radio minimum input voltage, which will cause the radio to shut off. Secondly, it enhances the operating time of battery backup power. If utility power provided to the cellular base station is interrupted and battery backup power is used, the amount of time the remote radio can run on battery power is increased before the battery voltage declines below a minimum voltage level, *i.e.* the minimum remote radio head input voltage plus the voltage drop on the power cable. Further, the programmable power supply can boost the battery voltage to maintain the remote radio head input voltage above its minimum; this effectively increases the useable power from the batteries.

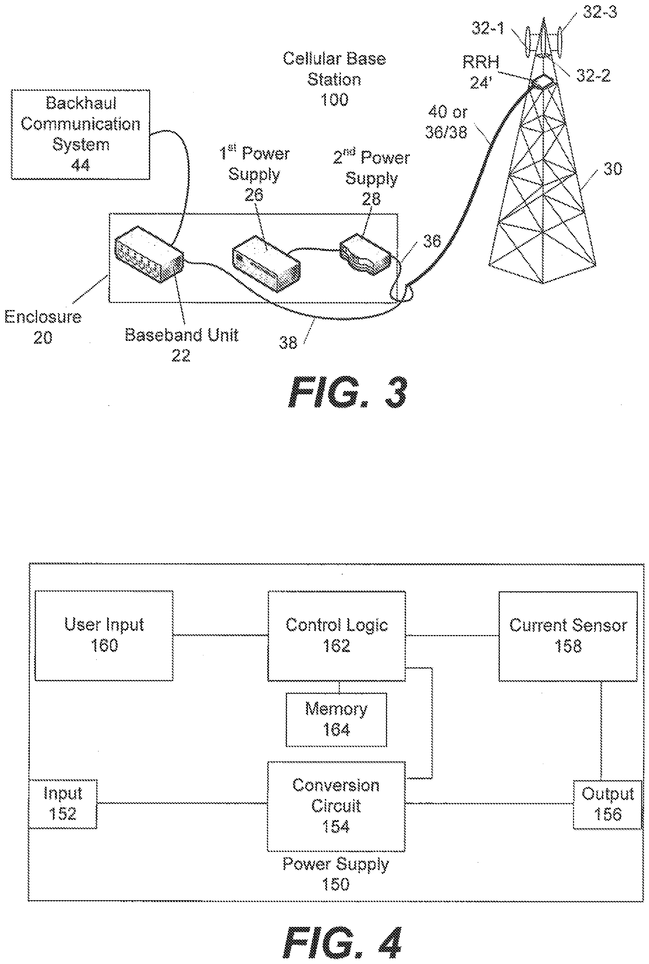

Embodiments of the present invention will now be discussed in more detail with reference to **FIGS. 3-14,** in which example embodiments of the present invention are shown.

**FIG. 3** is a schematic block diagram of a cellular base station **100** according to embodiments of the present invention. As shown in **FIG. 3,** the cellular base station **100** includes an equipment enclosure **20** and a tower **30.** The tower **30** may be a conventional antenna or cellular tower or may be another structure such as a utility pole or the like. A baseband unit **22,** a first power supply **26** and a second power supply **28** are located within the equipment enclosure **20.** An remote radio head **24'** and plurality of antennas **32** (e.g., three sectorized antennas **32-1, 32-2, 32-3**) are mounted on the tower **30,** typically near the top thereof.

The remote radio head **24'** receives digital information and control signals from the baseband unit **22** over a fiber optic cable **38** that is routed from the enclosure **20** to the top of the tower **30.** The remote radio head **24'** modulates this information into an RF signal at the appropriate cellular frequency that is then transmitted through one or more of the antennas **32.** The remote radio head **24'** also receives RF signals from one or more of the antennas **32,** demodulates these signals, and supplies the demodulated signals to the baseband unit **22** over the fiber optic cable **38.** The baseband unit **22** processes the demodulated signals received from the remote radio head **24'** and forwards the processed signals to the backhaul communications system **44.** The baseband unit **22** also processes signals received from the backhaul communications system **44** and supplies them to the remote radio head **24'.** Typically, the baseband unit **22** and the remote radio heads **24'** each include optical-to-electrical and electrical-to-optical converters that couple the digital information and control signals to and from the fiber optic cable **38.**

The first power supply **26** generates one or more DC power signals. The second power supply **28** in the embodiment of **FIG. 3** comprises a DC-to-DC converter that accepts the DC power signal output by the first power supply **26** as an input and outputs a DC power signal having a different voltage. A power cable **36** is connected to the output of the second power supply **28** and is bundled together with the fiber optic cable **38** so that the two cables **36, 38** may be routed up the tower **30** as an integral unit. In other embodiments, a hybrid power/fiber optic trunk cable **40** may be routed up the tower **30,** and jumper cables may be connected between each end of the trunk cable **40** and the baseband units **22,** power supply **28** and remote radio heads **24'.** In such embodiments, the power jumper cables and the power portion of the trunk cable **40** comprise the power cable **36.** While the first power supply **26** and the second power supply **28** are illustrated as separate power supply units in the embodiment of **FIG. 3,** it will be appreciated that the two power supplies **26, 28** may be combined into a single power supply unit in other embodiments.

As noted above, pursuant to embodiments of the present invention, DC power supplies are provided that may deliver a power signal to a remote radio head **24'** with reduced power loss. In the embodiment of **FIG. 3,** the power supply **28** comprises a programmable power supply that receives an input DC power signal from power supply **26** and outputs a DC power signal to the power cable **36**. Pursuant to embodiments of the present invention, the voltage of the DC power signal output by the power supply **28** may vary in response to variations in the current of the DC power signal drawn from the power supply **28** by the remote radio head **24'**. In particular, the voltage of the DC power signal output by the power supply **28** may be set, for example, so that the voltage of the DC power signal at the far end of the power cable **36** (i.e., the end adjacent the remote radio head **24'**) is relatively constant. If the voltage of the DC power signal at the far end of power cable **36** is set to be at or near the maximum specified voltage for the power signal of the remote radio head **24'**, then the power loss associated with supplying the DC power signal to the remote radio head **24'** over the power cable **36** may be reduced, since the higher DC power signal voltage will correspondingly reduce the current of the DC power signal that is supplied over the power cable **36.**

State-of-the-art remote radio heads **24'** are often designed to be powered by a 48 Volt (nominal) DC power signal. While the minimum DC power signal voltage at which the remote radio head **24'** will operate and the maximum DC power signal voltage that may be provided safely to the remote radio head **24'** without the threat of damage to the remote radio head **24'** vary, typical values are a 38 Volt minimum DC power signal voltage and a 56 Volt maximum DC power signal voltage. Thus, according to embodiments of the present invention, the programmable power supply **28** may be designed to deliver a DC power signal having a relatively constant voltage of, for example, about 54 or 52 Volts at the far end of the power cable **36** (i.e., about, 2-4 Volts less than the maximum DC power signal voltage for the remote radio head **24'**) in order to reduce the power loss associated with the voltage drop that the DC power signal experiences traversing the power cable **36.**

In order to maintain the voltage of the DC power signal at the far end of the power cable **36** at or near a predetermined value (or within a pre-selected range), it may be necessary to know two things. First, the current $I_{Cable}$ of the DC power signal drawn from the power supply must be known, as Equations (1) and (2) show that $V_{RRH}$ is a function of the current $I_{Cable}$. Second, the resistance $R_{Cable}$ of the power cable **36** must also be known, as it too affects the voltage drop. The programmable power supplies according to embodiments of the present invention may be configured to measure, estimate, calculate or receive both values.

For example, **FIG. 4** is a block diagram of a programmable power supply **150** in the form of a DC-to-DC converter according to certain embodiments of the present invention that may be used as the power supply **28** of **FIG. 3**. As shown in **FIG. 4,** the programmable power supply **150** includes an input **152**, a conversion circuit **154** and an output **156**. The power supply **150** further includes a current sensor **158**, a user input **160,** control logic (or control circuitry) **162** and a memory **164**.

The input **152** may receive a DC power signal such as the DC power signal output by power supply **26** of **FIG. 3**. The DC power signal that is received at input **152** may be a DC power signal having a relatively constant voltage in some embodiments. The conversion circuit **154** may be a circuit that is configured to convert the voltage of the signal received at input **152** to a different DC voltage. A wide variety of DC conversion circuits are known in the art, including, for example, electronic, electrochemical and electromechanical conversion circuits. Most typically electronic circuits using inductors or transformers are used to provide high efficiency voltage conversion. The output **156** may output the DC power signal having the converted voltage.

The current sensor **158** may be any appropriate circuit that senses the current level of the DC power signal output through the output **156**. For example, the current sensor **158** may be implemented using a resistor having a known value along the power supply conductor or the return conductor internal to the power supply **158,** along with a voltage meter that measures the voltage drop across the resistor, and the current may then be calculated according to Ohm's Law. It will also be appreciated that the current sensor **158** may be located external to the power supply **150** in other embodiments. The current drawn by the remote radio head **24'** may vary over time depending upon, for example, the number of carriers that are transmitting at any given time and whether the remote radio head **24'** is in a steady-state mode, powering up or rebooting. The current sensor **158** may sense the current level of the DC power signal at the output **156** and provide the sensed current level to the control logic **162**. The control logic **162** may then adjust parameters of the conversion circuit **154** so as to adjust the voltage of the DC power signal output through output **156** so that the voltage at the far end of the power cable **36** that is attached to output **156** may remain, for example, substantially constant despite changes in the current drawn by the remote radio head **24'** and corresponding changes in the voltage drop that occurs over the power cable **36**.

While **FIG. 4** illustrates a power supply **150** that comprises a DC-to-DC converter, it will be appreciated that in other embodiments an AC-to-DC converter may be used instead. In such embodiments, the input **152** receives an alternating current ("AC") power signal and the conversion circuit **154** converts the AC power signal to a DC power signal and also adjusts the voltage level of the DC power signal that is output through output **156** to an appropriate level in the manner discussed above.

As noted above, in some embodiments, the voltage of the power signal that is output by the power supply **150** may be set so that the voltage at the far end of the power cable **36** remains at or near a predetermined voltage level that is just under a maximum power signal voltage level that is specified for the remote radio head **24'**. In order to achieve this, it is necessary to know the voltage drop that the DC power signal will experience traversing the power cable **36,** as this voltage drop affects the voltage of the DC power signal at the far end of the power cable **36.** In some embodiments, the user input **160** to the power supply **150** allows a user to input a cumulative resistance value for the power cable **36** which the user may obtain by, for example, calculation (based on the length, size and material of the conductor of the power cable **36**), measurement (done, for example, by transmitting a signal over the power cable **36** and measuring the voltage of the signal output at the far end of the power cable **36**) or a combination thereof (e.g., measuring or estimating a cumulative impedance value for the power cable **36** and converting this cumulative impedance value into a cumulative resistance value). In other embodiments, the user may input physical characteristics of the power cable **36** such as size, length, conductor material, model number, etc.) and algorithms, equations, look-up tables and the like that are stored in the memory **164** of the power supply **150** may be used to calculate or estimate the resistance of the power cable **36.** In still other embodiments, the resistance of the power cable **36** may already be known because it was measured or otherwise determined by the cable manufacturer. By way of example, the power cable **36** may have the resistance printed on the jacket thereof, coded into a bar code that is provided on the power cable **36** or stored in an RFID chip that is part of the power cable.

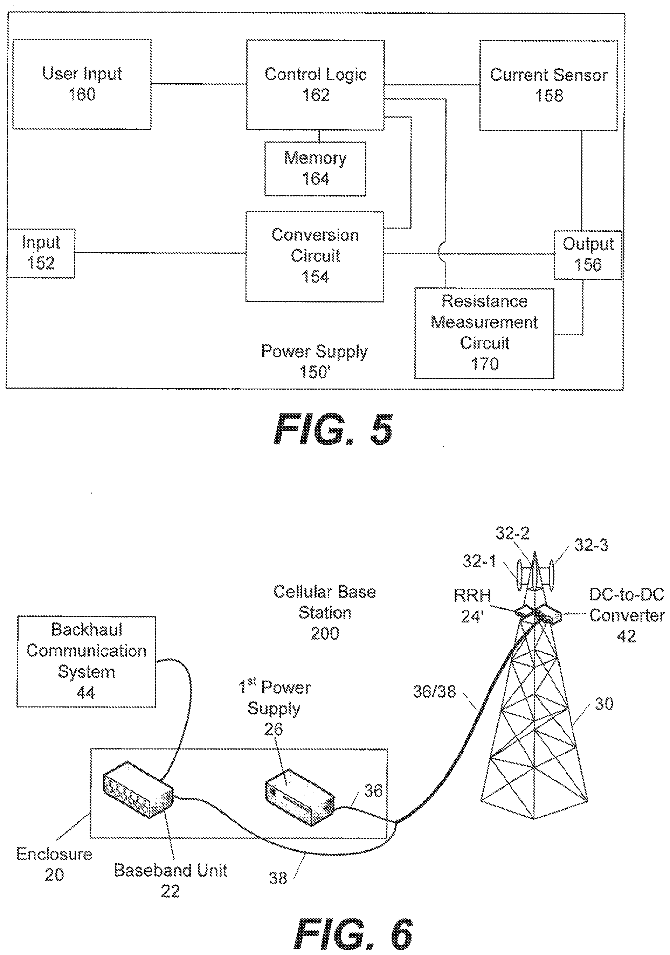

In some embodiments, the second power supply **28** of **FIG. 3** may further be configured to measure a resistance of the power cable **36.** For example, **FIG. 5** is a block diagram of a programmable power supply **150'** according to further embodiments of the present invention that may be used to implement the power supply **28** of **FIG. 3.** The power supply **150'** is very similar to the power supply **150** of **FIG. 4,** except that it further includes a cable resistance measurement circuit **170** that may be used to measure a resistance of the power supply cable. The cable resistance measurement circuit **170** may be implemented in a variety of ways. For example, in some embodiments, the cable resistance measurement circuit **170** may transmit a voltage pulse onto the power cable **36** and measure the reflected return pulse (the far end of the power cable may be terminated with a termination having known characteristics). The current of the voltage pulse may be measured, as well as the voltage level of the reflected return pulse. The control logic **162** may then apply Ohm's law to calculate the resistance of the power cable **36.** In other embodiments, at the far end of the power cable **36** the two conductors thereof may be shorted and a voltage pulse may again be transmitted through the power cable **36.** The current level of the pulse and the voltage level of the return pulse may be measured and the control logic **162** may again use these measured values to calculate the resistance of the power cable **36.** In other embodiments, the DC resistance can be measured by transmitting alternating current signals at different frequencies over the power cable **36** and measuring the amplitude and phase shift of these signals at the far end of the power cable **36.** The DC resistance may then be calculated using the measured results. Other ways of measuring the resistance of a wire segment are known to those of skill in the art and may be used instead of the example methods listed above. Additional techniques for determining the resistance are also discussed below.

It will also be appreciated that in other embodiments the resistance measurement circuit **170** may measure an impedance of the power cable **36** and use this measured impedance value to determine the resistance of the power cable **36.** It will also be appreciated that the power supply **150'** may alternatively comprise an AC-to-DC converter, similar to power supply **150** discussed above.

Another technique for reducing the power loss associated with supplying power to a tower-mounted remote radio head of a cellular base station is to dramatically increase the voltage of the DC power signal fed to the power cable that supplies the DC power signal to the remote radio head (i.e., well beyond the maximum specified voltage for the DC power signal that can be handled by the remote radio head), and then using a tower-mounted DC-to-DC converter power supply to step-down the voltage of the DC power signal to a voltage level that is appropriate for the remote radio head. As the increased voltage reduces the current necessary to supply the wattage required by the remote radio head, the power loss along the power cable may be reduced (see Equation (2) above). This is referred to as a "Buck-Boost" scheme where the DC-to-DC converter at the bottom of the tower is a "Boost" converter that increases the voltage of the DC power signal above the necessary level to operate the remote radio head and the DC-to-DC converter at the top of the tower is a "Buck" converter that reduces the voltage of the DC power signal to a desired level. **FIG. 6** is a simplified, schematic view of a cellular base station **200** that implements such a technique.

As shown in **FIG. 6,** the cellular base station **200** is similar to the cellular base station **100** described above with reference to **FIG. 3,** except that the cellular base station **200** further includes a third power supply **42** in the form of a tower-mounted DC-to-DC converter. In the depicted embodiment, the second power supply **28** of **FIG. 3** is omitted, and the first power supply **26** is configured to supply a DC power signal having a voltage that is significantly higher than the maximum voltage for the DC power signal that may be supplied to the remote radio head **24'** (e.g., a 150 volt DC power signal). This high voltage DC power signal may experience significantly less power loss when traversing the power cable **36.** The DC-to-DC converter **42** is mounted at the top of the tower **30** between the far end of cable **36** and the remote radio head **24'.** The DC-to-DC converter **42** may be a Buck converter that decreases the voltage of the DC power signal received over the power cable **36** to a voltage level appropriate for supply to the remote radio head **24'.**

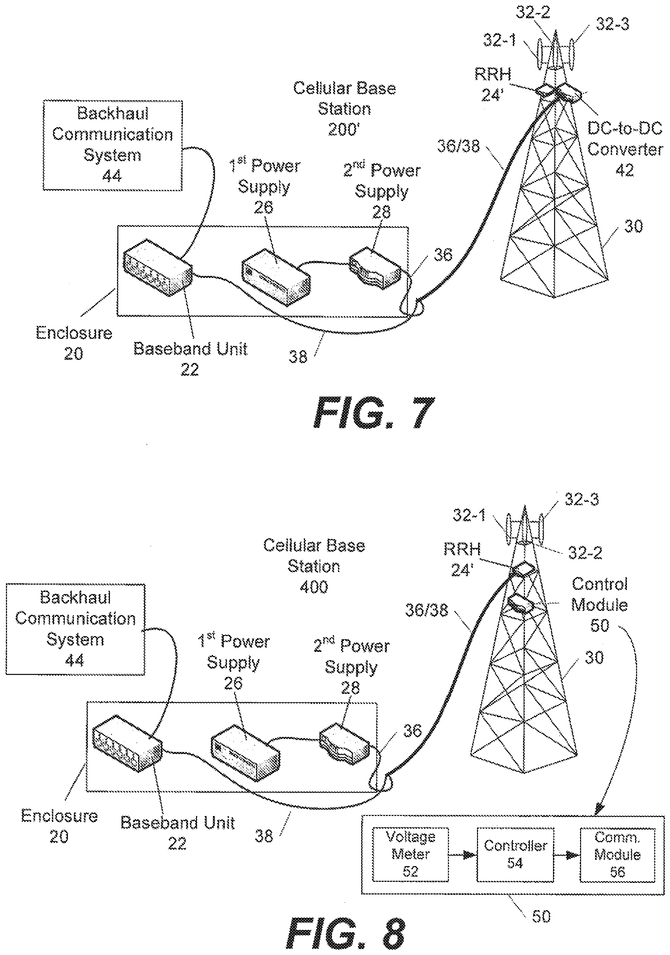

As is shown in **FIG. 7,** in other embodiments, the second power supply **28** may be included in the form of, for example, a DC-to-DC Boost power converter **28** that supplies a high voltage DC power signal (e.g., 150 volts) to the power cable **36.** In this embodiment, a DC-to-DC converter is provided at both ends of the power cable **36** so that both of the above-described techniques for reducing power losses in the power cable **36** may be implemented. In particular, the second power supply **28** may output a DC power signal having high voltage (e.g., on the order of 150 volts) that fluctuates with power requirements of the remote radio head **24'** so that the DC power signal that is supplied at the far end of power cable **36** is set at a relatively constant value. The tower-mounted DC-to-DC converter **42** may be a simple device that down-converts the voltage of the DC power signal by a fixed amount X. The power supply **28** may be programmed to deliver a DC power signal to the tower-mounted DC-to-DC converter **42** that has a voltage level that is set as follows:

$$\text{Voltage of Delivered Power Signal} = V_{RRH\text{-}Max} - V_{margin} + X \qquad (4)$$

where $V_{RRH\text{-}Max}$ is the maximum power signal voltage that the remote radio head **24'** is specified to handle, $V_{margin}$ is a predetermined margin (e.g., 2 Volts), and X is the magnitude of the voltage conversion applied by the tower-mounted DC-to-DC converter **42.**

One disadvantage of the approaches of **FIGS. 6** and **7** is that they require the installation of additional equipment (i.e., the DC-to-DC converter **42**) at the top of the tower **30**. As the cost associated with sending a technician up a tower may be very high, there is generally a preference to reduce or minimize, where possible, the amount of equipment that is installed at the top of a cellular base station tower, and the equipment that is installed at the top of cellular towers tends to be expensive as it typically is designed to have very low failure rates and maintenance requirements in order to reduce the need for technician trips up the tower to service the equipment. The inclusion of an additional DC-to-DC converter **42** also represents a further increase in capital expenditures, which must be weighed against the anticipated savings in operating costs.

Thus, pursuant to embodiments of the present invention, a DC power signal may be supplied to a tower-mounted remote radio head (or other equipment) of a cellular base station over a power cable, where the DC power signal that is supplied to the remote radio head may have, for example, a relatively constant voltage level or a voltage level within a pre-selected range, regardless of the current drawn by the remote radio head. The voltage level of the DC power signal supplied to the remote radio head may be set to be at or near a maximum power signal voltage that the remote radio head can handle, thereby reducing the power loss of the DC power signal. In this manner, the operating costs for the cellular base station may be reduced.

In some embodiments, the programmable power supply according to embodiments of the present invention may comprise a DC-to-DC converter that may be connected between a power supply of an existing base station and the power cable that supplies the power signal to a tower-mounted remote radio head. Thus, by adding a single piece of equipment at the bottom of the tower, an existing cellular base station may be retrofitted to obtain the power savings available using the techniques according to embodiments of the present invention.

While the above-described embodiments of cellular base stations according to embodiments of the present invention include a first, conventional DC power supply **26** and a second DC-to-DC converter power supply **28,** it will be appreciated that in other embodiments these two power supplies may be replaced with a single programmable power supply that may be configured to output a relatively constant voltage at the far end of the power cable **36** in the manner described above.

Pursuant to further embodiments of the present invention, a feedback loop may be used to control the voltage of the DC power signal output by the DC power supply so that the voltage of the DC power signal at the far end of the power cable that connects the power supply and the remote radio head is maintained at a desired level or within a desired range. **FIG. 8** is a simplified, schematic view of one example embodiment of a cellular base station **400** that implements such a technique.

As shown in **FIG. 8,** the cellular base station **400** is similar to the cellular base station **100** described above with reference to **FIG. 3,** except that the cellular base station **400** further includes a DC power signal voltage control module **50** that is co-located with the remote radio head **24'**. The DC power signal voltage control module **50** may be located, for example, at or near the top of the tower **30**. In an example embodiment, the DC power signal voltage control module **50** may include a voltage meter **52,** a controller **54** and a communications module **56**. The voltage meter **52** may be used to monitor the voltage of the DC power signal at the far end of the power cable **36** (i.e., at the top of the tower **30**). Any appropriate voltage meter may be used that is capable of measuring the voltage of the DC power signal at the far end off cable **36** (or at another location proximate the remote radio head **24'**) or that may measure other parameters which may be used to determine the voltage of the DC power signal at the far end off cable **36.**

The voltage meter **52** may supply the measured voltage (or other parameter) to the controller **54**. The controller **54** may then control the communications module **56** to transmit the measured or calculated voltage of the DC power signal at the far end of power cable **36** to, for example, the second power supply **28**. The controller **54** may comprise any appropriate processor, controller, ASIC, logic circuit or the like. The communications module **56** may comprise a wired or wireless transmitter. In some embodiments, the communications module **56** may comprise a wireless Bluetooth transmitter or a cellular transmitter. In other embodiments, the communications module **56** may communicate with the second power supply **28** over a separate wired connection. In still other embodiments, the communications module **56** may communicate with the second power supply **28** by modulating a signal onto the power cable **36**. In each case, the communications module **56** may transmit the measured or calculated voltage of the DC power signal at the far end of power cable **36** (i.e., at the top of the tower **30**) to the second power supply **28**. The second power supply **28** may adjust the voltage of the DC power signal that it outputs in response to these communications in order to generally maintain the voltage of the DC power signal at the far end of power cable **36** at a desired and/or pre-selected level or range. Thus, in this embodiment, an active feedback loop may be used to maintain the voltage of the DC power signal at the far end of power cable **36** at the pre-selected level.

The power signal voltage control module **50** may be a standalone unit or may be integrated with other equipment such as, for example, the remote radio head **24'**.

While the embodiments that have been described above deliver a DC power signal over the power cable **36**, it will be appreciated that in other embodiments, an AC power signal may be used instead. For example, if the remote radio heads **24'** are designed to be powered by an AC power signal as opposed to a DC power signal, then the power supply **28** may output an AC power signal as opposed to a DC power signal, but may otherwise operate in the same fashion. Likewise, in embodiments that include a DC-to-DC converter **42** at the top of the tower **30**, an AC-to-DC converter may be used instead or, if the remote radio head **24'** is designed to be powered by an AC power signal, the DC-to-DC converter **42** may be replaced with a Buck AC-to-AC converter. Thus, it will be appreciated that the embodiments illustrated in the figures are exemplary in nature and are not intended to limit the scope of the present invention.

In the various embodiments described above, a single power cable **36** has been provided that connects the power supply **28** to the remote radio head **24'**. It will be appreciated, however, that the cabling connection for the power signal between the power supply **28** and the remote radio head **24'** may include multiple elements such as two or more power cables **36** that are connected by connectors in other embodiments.

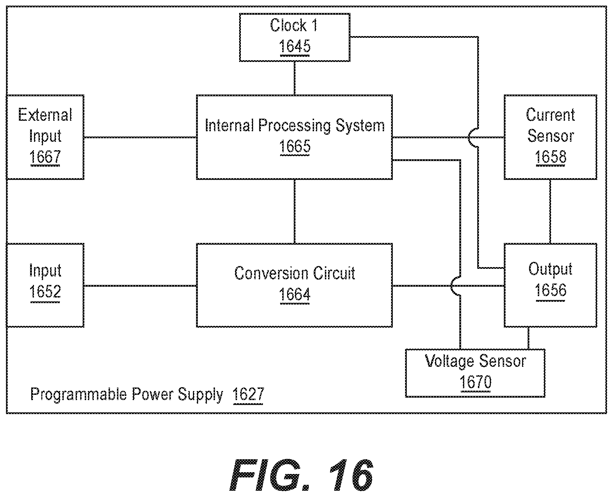

FIG. 16 is a simplified, block diagram of a programmable power supply **1627** according to yet further embodiments of the present invention. The programmable power supply **1627** includes an input **1652,** an output **1656,** and a current sensor **1658** coupled to a conversion circuit **1664,** each of which provides the same functionality are as described for their counterparts illustrated in **FIGS. 4** and **5.** In other embodiments, the programmable power supply **1627** further includes an internal processing system **1665,** external input **1667,** a voltage sensor **1670,** and/or a first clock (clock 1) **1645** to respectively facilitate external communications, measurement of programmable power supply output voltage, and time stamping or synchronizing of measurements.

The internal processing system **1665** coupled to the external input **1667**. In one embodiment, the internal processing system **1665** provides the same functionality as the control logic **162** and memory **164** illustrated in **FIGS. 4** and **5.** In another embodiment, the internal processing system **1665** controls the level of voltage (and possibly the level of current), of the programmable power supply **1627** at the output **1656,** regardless of the mechanism dictating the voltage level (and current level).

The external input **1667** comprises one or more data input mechanisms, including for example a touch pad and/or an electronic interface such as an Ethernet interface. In one embodiment, the external input **1667** obtains data including that provided by the user input **160** illustrated in **FIGS. 4** and **5.** In another embodiment, the external input **1667** is used to input at least one desired voltage level at the output **1656** of the programmable power supply **1627,** *e.g.* by a system, for example a processing system, or by a user. In a further embodiment, the external input **1667** is coupled to the control module **50** and is configured to receive voltage level(s) measured proximate to the input of the RRH **24'** on the power cable **36**. In yet another embodiment, the external input **1667** is configured to receive time and/or clock data, *e.g.* corresponding to each voltage level measurement.

In one embodiment, the programmable power supply **1627** further includes the voltage sensor **1670** coupled to the output **1656** and the external processing system **1665**. The voltage sensor **1670** measures the voltage level at the output **1656** of the programmable power supply **1627**. Such measurements are conveyed by the voltage sensor **1670** to the internal processing system **1665**.

In one embodiment, the programmable power supply **1627** further includes the first clock (clock 1) **1645** coupled to the internal processing system **1665**. In another embodiment, the first clock **1645** generates a time corresponding to the time of each measurement, *e.g.* current sensor **1658** measurement and/or voltage sensor **1670** measurement, of the programmable power supply **1627**. The time may be actual time, or a relative time associated with operation of the cellular base station **1700**. In a further embodiment, a processing system, *e.g.* the internal processing system **1665**, stores the measurement data with the corresponding time data so that a time is associated with each measurement.

In one embodiment, the first clock **1645** is coupled to the output **1656,** and generates a clock signal or time pulse to be conveyed to the control module **50** on the power cable **36**. In another embodiment, the clock signal provides a time to the control module **50** so that a clock in the control module **50** has the same time as the first clock **1645**. In a further embodiment, the time pulse is alternatively provided to ensure that the first clock **1645** is synchronized with the clock in the control module **50**.

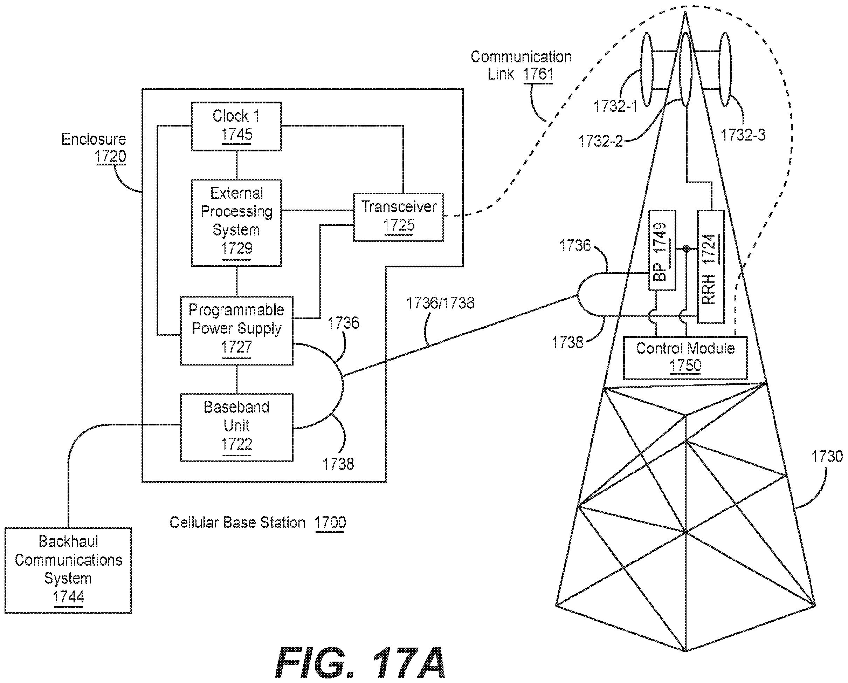

**FIG. 17A** is a simplified, schematic view of a cellular base station **1700** according to yet further embodiments of the present invention. As shown in **FIG. 17A,** the depicted cellular base station **1700** includes an equipment enclosure **1720** and an antenna tower **1730**. As discussed above, the equipment enclosure **1720** is typically located at the base of the antenna tower **1730**. In one embodiment, a baseband unit **1722** and a programmable power supply **1727** are located within the equipment enclosure **1720**. The baseband unit **1722** may be in communication with a backhaul communications system **1744**. A plurality of antennas **1732** (e.g., three sectorized antennas **1732-1,1732-2,1732-3**) are located at the top of the antenna tower **1730**. A remote radio head (RRH) **1724** is located proximate to the top of the antenna tower **1730,** and is coupled to the baseband unit **1722** and the programmable power supply **1727** respectively by a fiber optic cable **1738** and a power cable **1736**.

In one embodiment, as described above, a control module **1750** is mounted on the antenna tower **1730** proximate to the remote radio head **1724**. In another embodiment, the control module **1750** is coupled to the programmable power supply **1727** or an external processing system **1729** through a communications link **1761**. In a further embodiment, a transceiver **1725** is coupled between the communications link **1761,** and the programmable power supply **1727** or an external processing system **1729**. In yet another embodiment, the transceiver **1725** modulates and/or demodulates data transmitted to and received from the control module **1750** through the communications link **1761**. In yet a further embodiment, the transceiver **1724** is just a receiver that demodulates signals received from the control module **1750**. In another embodiment, the transceiver **1725** is located in the enclosure **1720**. In a further embodiment, the control module **1750** measures the voltage on the power cable **1736** proximate to the remote radio head **1724**.

As described above, the communications link **1761** is a wired or wireless communications link. When a wired communications link, the communications link **1761** can be an existing wired connection (*e.g.* a RS-485 serial communications link or a communications link, *e.g.* using alternating current (AC) signal transmission, over the power cable **1736**) or an additional wired communications link of any type. When a wireless communications link, the communications link **1761** can be a Bluetooth, Wi-Fi, cellular network, or any other type of wireless communications link.

In one embodiment, a bypass circuit (BP) **1749** is coupled between the power cable **1736** to the remote radio head **1724**. In another embodiment, the bypass circuit **1749** is mounted on the tower **1730** proximate to the remote radio head **1724**. In a further embodiment, the control signals to actuate the bypass circuit **1749** are alternating current (AC) signals transmitted on the power cable **1736**. In yet another embodiment, the control module **1750,** through the communications link **1761,** receives a control signal to actuate and deactivate the bypass circuit **1749**.

In one embodiment, the bypass circuit **1749** is configured to couple together, or not, a first conductor and a second conductor of the power cable **1736**. When the two conductors are coupled, the programmable power supply **1727** can supply a current through the power cable **1736** so that the resistance of the cable can be determined, *e.g.* by a processing system.

In one embodiment, the bypass circuit **1749** is configured to either isolate the programmable power supply **1727** from the remote radio head **1724** and couple together a first conductor and a second conductor of the power cable **1736,** or to couple the power cable **1736** to the remote radio head **1724** and isolate the first conductor and the second conductor. However, isolation of the programmable power supply is optional when coupling together the first conductor and the second conductor. When the two conductors are coupled, the programmable power supply **1727** can supply an AC or DC current through the power cable **1736** so that the resistance of the cable can be determined, *e.g.* by a processing system. For example for DC current, the resistance can be determined by dividing the DC voltage by the DC current. For example, for AC current, the resistance can be determined by dividing root mean squared (RMS) voltage by RMS current. Thus, when the cellular base station **1700** is not normally operating, *e.g.* during maintenance, the bypass circuit **1749** can be used to disconnect the power cable **1736** from the remote radio head **1724,** and to couple two conductors of the power cable **1736**. In another embodiment, if AC current is supplied, the AC frequency should be sufficiently low to diminish skin effect losses.

In one embodiment, an external processing system **1729** is coupled to the programmable power supply. In another embodiment, the external processing system **1729** controls the voltage level of the programmable power supply **1727,** and determines and/or stores the resistance of the power cable **1736**. In a further embodiment, the external processing system **1729** is in the enclosure **1720**.

In one embodiment, the first clock (clock 1) **1745** is located outside of the programmable power supply. In another embodiment, the first clock **1745** is coupled to the external processing system **1729,** programmable power supply **1727,** and/or transceiver **1725**. In a further embodiment, the first clock **1745** is in the enclosure **1720**. In yet another embodiment, the first clock **1745** resides within the external processing system 1729.

In one embodiment, the first clock **1745** generates a synchronizing clock signal or time pulse to be conveyed to the control module **1750** through the power cable **1736** or the communications link **1761**. In another embodiment, the synchronizing clock signal or time pulse is used to ensure that the first clock **1745** is synchronized with a clock in the control module **1750**. Synchronizing clock signal or time pulse can also be used to permit the programmable power supply **1727** and the control module to take voltage measurements at the same time so that voltage and current measurements can be time correlated.

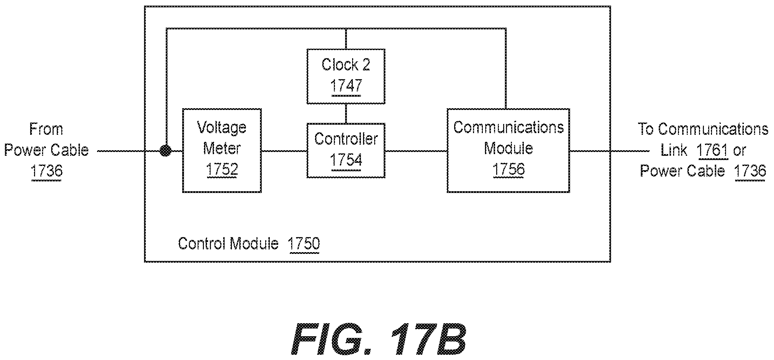

FIG. 17B is a simplified, block diagram of a control module **1750** according to yet further embodiments of the present invention. The control module **1750** of **FIG. 17B** comprises a controller **1754** coupled to a communications module **1756**. In one embodiment, the control module **1750** can be used to control the bypass circuit **1749**. The communications module **1756** receives control signals, to actuate and deactivate the bypass circuit **1749,** through the communications link **1761** or the power cable **1736**. The communications module **1756** provides such control signals to the controller **1754** which then activates and deactivates the bypass circuit **1749**.

In one embodiment, the control module **1750** of **FIG. 17B** also includes a voltage meter **1752** coupled to the power cable **1736** proximate to the remote radio head **1724**. The voltage meter **1752** is configured to measure the voltage on the power cable **1736** proximate to the remote radio head **1724**.

In one embodiment, the control module **1750** of **FIG. 17B** also includes a second clock (clock 2) **1747** coupled to the controller **1754**. In another embodiment, the second clock **1747** is coupled to the power cable **1736** and/or the communications module 1756. In a further embodiment, the second clock **1747** generates a time corresponding to the time of each measurement, *e.g.* by the voltage meter **1752**. The time may be actual time, or a relative time associated with operation of the cellular base station **1700**. In this embodiment, the communications module **1756** provides, a processing system, *e.g.* the internal processing system **1665** or external processing system **1729,** with the measurement data and corresponding measurement time data so that a time of each control module measurement can be recorded.

In one embodiment, the second clock **1747** is coupled to the first clock **1645, 1745** by the power cable **1736** or communications link **1761**. The second clock **1747** is configured to receive the synchronizing clock signal or time pulse from the first clock **1645, 1745**. In another embodiment, the synchronizing clock signal or time pulse ensures that the second clock **1747** is synchronized with the first clock **1645, 1745**.

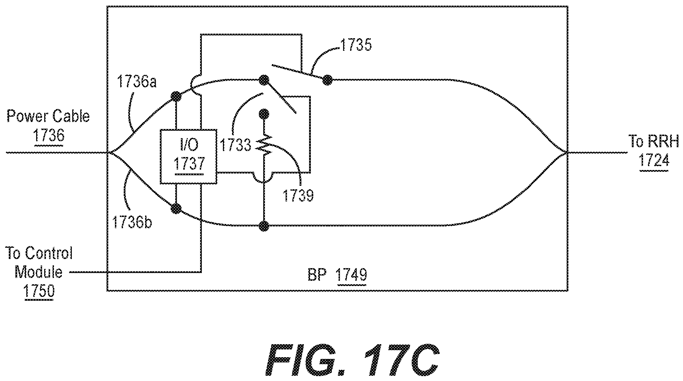

FIG. 17C is a simplified, schematic diagram of a bypass circuit (BP) **1749** according to yet further embodiments of the present invention. In one embodiment, the bypass circuit is coupled between the power cable **1736** and the remote radio head **1724**. In another embodiment, the power cable **1736** includes a first conductor **1736a** and a second conductor **1736b**. In a further embodiment, the bypass circuit **1749** is controlled by the control module **1750,** *e.g.* through the communications link **1761,** through alternating current signals propagated on the power cable **1736,** or by the remote radio head **1724**.

The bypass circuit **1749** comprises a first switch **1733,** and an input / output interface circuit (I/O) **1737**. In one embodiment, the bypass circuit **1749** also includes a second switch **1735** which isolates the remote radio head **1724** so that its input impedance does not affect the determination of the power cable **1736** resistance. In another embodiment, the bypass circuit is coupled between the power cable **1736** and the remote radio head **1724**. In a further embodiment, the power cable **1736** includes a first conductor **1736a** and a second conductor **1736b**.

The first switch **1733** is coupled between the first conductor **1736a** and the second conductor **1736b**. In one embodiment, when the second switch **1735** is used, the first switch **1733** is also coupled between an input / output interface circuit **1737** and the second switch **1735**. The second switch **1735** is coupled between the first switch **1733** and the remote radio head **1724**. The second switch **1735** is also coupled in series with the first conductor **1736a**.

The input / output interface circuit **1737** is coupled between the first conductor **1736a** and the second conductor **1736b,** and is coupled to the first switch **1733**. In one embodiment, the input / output interface circuit **1737** is coupled to the second switch **1735**. The input / output interface circuit **1737** is also coupled to the power cable **1736** prior to being coupled the first switch **1733** and/or the second switch **1735**. The input / output interface circuit **1737** is configured to measure the voltage across the first conductor **1736a** and the second conductor **1736b**. In one embodiment, the first switch **1733** and the second switch **1735** are electromechanical relays or field effect transistor switches. In another embodiment, the measured voltage is conveyed to, and received by, a processing system, *e.g.* the internal processing system **1665** or the external processing system **1729,** through the control module **1750** or the power cable **1736**.

Based upon control signals received, *e.g.* through the power cable **1736,** remote radio head **1724,** or control module **1750,** the input / output interface circuit **1737,** *e.g.* including any driver circuits, causes the first wire **1736a** and the second wire **1736b** to respectively be coupled or not. During normal operation of the cellular base station **1700,** the first switch **1733** is open, and the first wire **1736a** and the second wire **1736b** are not coupled. When power cable resistance is being determined, the first switch **1733** is closed, and the first wire **1736a** and the second wire **1736b** are coupled.

In one embodiment, during normal operation, when the first switch **1733** and the second switch **1735** are used, the first switch **1733** and the second switch **1735** are respectively opened and closed. When power cable resistance is being determined, the first switch **1733** and the second switch **1735** are respectively closed and opened. The open second switch 1735 isolates the power cable 1736 from the remote radio head **1724**.

When the bypass circuit **1749** is enabled, the first switch **1733** is closed and power to the remote radio head **1724** is diminished. In one embodiment, when the first switch **1733** and the second switch **1735** are used and when the bypass switch is circuit **1749** is enabled, the first switch **1733** and the second switch 1735 are respectively closed and opened. In this embodiment, a low resistance circuit is formed between the first conductor **1736a** and the second conductor **1736b**. Current supplied by the programmable power supply **1727** is limited to avoid damaging the programmable power supply **1727.** Based upon the voltage of, and the current drawn from, the programmable power supply **1727,** a processing system can determine the total resistance of the first conductor **1736a,** the second conductor **1736b** of the power cable **1736,** and the bypass circuit **1749.** In another embodiment, the resistance of the bypass circuit **1749,** when the first switch **1733** and the second switch **1735** are respectively closed and opened, has been previously characterized and thus can be subtracted from the total measurement. After the subtraction, the resistance of the power cable **1736** is determined a quotient by dividing in one-half the total resistances of the first conductor **1736a** and the second conductor **1736b;** this assumes that the first conductor **1736a** and the second conductor **1736b** are equivalent in length and cross section.

In one embodiment, a resistor **1739,** *e.g.* a precision resistor, is inserted between the second switch **1733** and one of the first conductor **1736a** and the second conductor **1736.** If it has sufficient resistance and power handling capacity, the resistor eliminates the need to current limit, and reduces the risk of damage to, the programmable power supply **1727.**

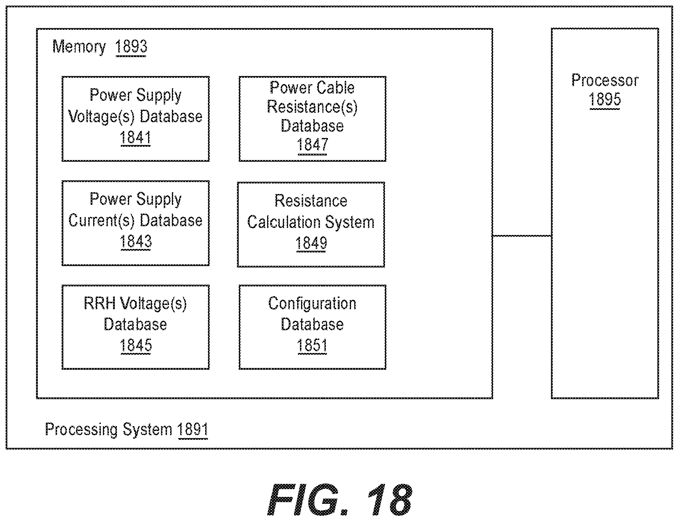

FIG. 18 is a simplified block diagram of a processing system **1891** according to yet further embodiments of the present invention. In one embodiment, the processing system **1891** is either the internal processing system **1665** of the programmable power supply **1627** or the external processing system **1729** of the cellular base station **1700.** In another embodiment, the processing system **1891** includes a processor **1895,** such as a microprocessor, microcontroller, or digital signal processor, coupled to a memory **1893.** However, the processing system **1891** may be alternatively implemented with a state machine, an application specific integrated circuit, or a field programmable gate array.

In one embodiment, the memory **1893** includes a power supply voltage(s) database **1841,** a power supply current(s) database **1843,** a remote radio head voltage(s) database **1845,** a cable resistance(s) database **1847,** and a configuration database **1851.** Although referred to as 'databases,' each of such databases may be a database either in the conventional sense or any other form of storing data, *e.g.* a data file. Optionally, in another embodiment, two or more of the databases may be combined into a single database.

The power supply voltage(s) database **1841** stores at least one voltage level of the output **1656** of the programmable power supply **1627,** *e.g.* measured by the voltage sensor **1670.** In one embodiment, the corresponding time of measurement of the voltage level of the output **1656** is stored with the corresponding voltage level in the power supply voltage(s) database **1841.**

The power supply current(s) database **1843** stores at least one current level of the output **1656** of the programmable power supply **1627,** *e.g.* measured by the current sensor **1658.** In one embodiment, the corresponding time of measurement of the current level of the output **1656** is stored with the corresponding current in the power supply current(s) database **1843.** In another embodiment, the voltage level and current level measured at the same time are stored in the power supply voltage(s) database **1841;** thus no power supply current(s) database **1843** is needed. In a further embodiment, the voltage level and current level measured at the same time, and the corresponding measurement time are stored in the power supply voltage(s) database **1841.**

The remote radio head (RRH) voltage(s) database **1845** stores at least one voltage level on the power cable **1736** proximate to the remote radio head **1724,** *e.g.* measured by the control module **1750.** In one embodiment, the corresponding time of measurement of the voltage level on the power cable **1736** proximate to the remote radio head **1724** is stored with the corresponding voltage level in the remote radio head voltage(s) database **1845.** In another embodiment, the voltage level on the power cable **1736** proximate to the remote radio head **1724** may be stored in the power supply voltage(s) database **1841;** with the voltage level and/or current level, of the power supply current(s) database **1843,** measured at or about the same time.

The power cable resistance(s) database **1845** stores at least one resistance of the power cable **1736** determined, or calculated, by the processing system **1891.** The resistance calculation system **1849** determines the resistance(s) of the power cable **1736** stored in the power cable resistance(s) database **1845.** In one embodiment, at least one resistance of the power cable **1736** is calculated with the resistance calculation system **1849** using the data stored in the power supply voltage(s) database **1841** and the power supply current(s) database **1843.** In another embodiment, at least one resistance of the power cable **1736** are calculated with the resistance calculation system **1849** using the data stored in the power supply voltage(s) database **1841,** the power supply current(s) database **1843,** and the remote radio head voltage(s) database **1845.** In a further embodiment, the resistance calculation system **1849** and data from the power supply voltage(s) database **1841,** the power supply current(s) database **1843,** and/or the remote radio head voltage(s) database **1845** are executed on the processor **1895.**

In one embodiment, the configuration database **1851** that stores configuration data, including data corresponding to at least one target voltage of the output **1656** of the programmable power supply **1627** when determining the resistance of the power cable **1736,** maximum and minimum operating voltages of the remote radio head **1724,** a desired constant voltage on the power cable **1736** proximate to the remote radio head **1724,** resistance of bypass circuit **1749,** a time window, and/or prior measurement or estimate of the power cable **1736** resistance. In another embodiment, optionally, the configuration database **1851** includes a voltage window, *e.g.* an upper and lower voltage threshold or a single absolute voltage threshold, used when determining the resistance of the power cable **1736.**

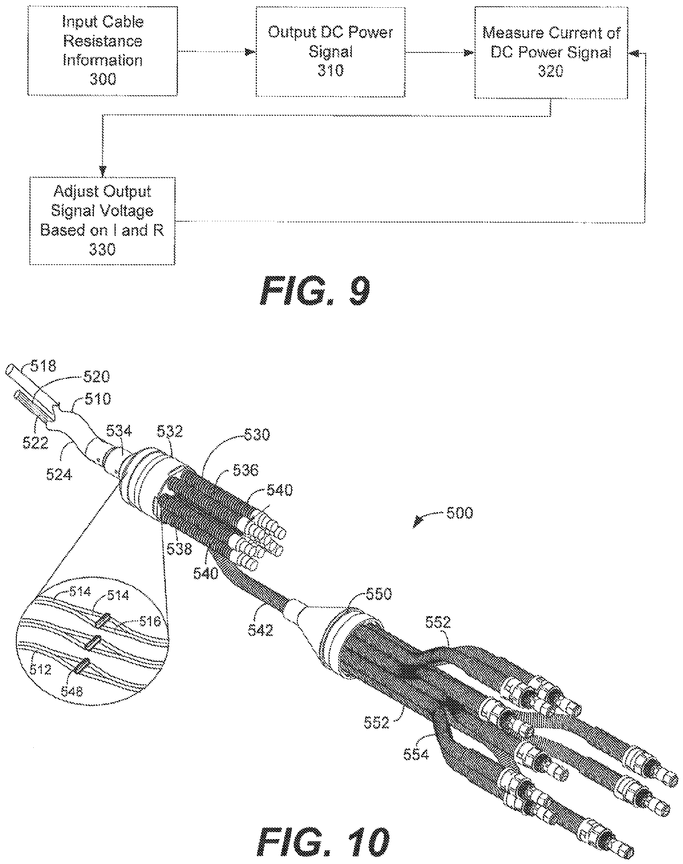

A method of powering a radio that is mounted on a tower of a cellular base station according to embodiments of the present invention will now be described with reference to the flow chart of **FIG. 9.** As shown in **FIG. 9,** operations may begin with a user inputting information to a programmable power supply which may be used by the programmable power supply to set a voltage level of the power signal that is output by the programmable power supply (block **300).** This information may comprise, for example, an electrical resistance of a cabling connection between the power supply and the radio or information regarding the characteristics of the cabling connection that may be used to calculate this resistance. While not shown in **FIG. 9,** it will be appreciated that in other embodiments the programmable power supply may have the capability to measure and/or calculate the resistance of the cabling connection, thereby avoiding the need for any user input. The programmable power supply may use this information to output a DC power signal that is provided to the remote radio head over the cabling connection (block **310).** The current of the DC power signal that is output may then be measured (block **320).** The programmable power supply may then automatically adjust a voltage level of the power signal output by the power supply in response to changes in the measured output current so that the power signal that is input to the remote radio head will have a substantially constant, preselected voltage (block **330).** As shown in **FIG. 9,** blocks **320** and **330** are then performed continuously at appropriate intervals in order to maintain the voltage level of the power signal that is input to the remote radio head at the preselected voltage level.

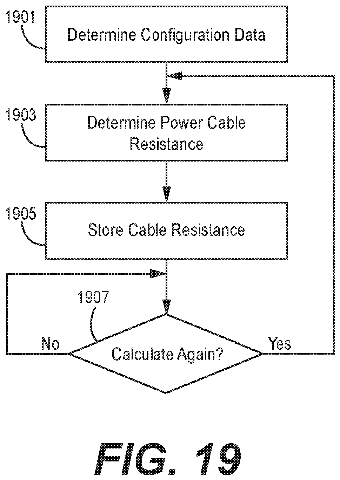

**FIGS. 19-22** illustrate embodiments of methods. To the extent that the embodiments of methods are described herein as being implemented in or with the apparatus or systems described herein, it is to be understood that the embodiments can be implemented in other ways. The blocks of the flow diagrams have been arranged in a generally sequential manner for ease of explanation; however, it is to be understood that this arrangement is merely exemplary, and it should be recognized that the processing associated with the methods (and the blocks shown in the Figures) can occur in a different order (for example, where at least some of the processing associated with the blocks is performed in parallel and/or in an event-driven manner).

**FIG. 19** is a flow chart illustrating operations of methods of determining the resistance of the power cable **1736** according to yet further embodiments of the present invention. In block **1901,** determine configuration data used for determining the resistance of the power cable **1736.** In one embodiment, such calibration parameters include an estimate or prior measurement of the resistance of the power cable **1736,** a desired remote radio head voltage, a time window, and/or an initial programmable power supply output voltage. In another embodiment, such parameters are stored in the configuration database **1851.**

In block **1903,** using the configuration data, determine, or calculate, the resistance of the power cable **1736** coupling a programmable power supply **1727** to a remote radio head **1724** mounted on a tower **1730.** In block **1905** store the resistance of the power cable **1736.**

In one embodiment, in block **1907** determine whether to again calculate the resistance of the power cable **1736.** If yes, return to block **1903.** If no, return to block **1907** and determine whether to again determine the resistance of the power cable **1736.** In another embodiment, again calculate the the resistance of the power cable **1736** when (a) the remote radio head **1724** is disabled or is not receiving signals from the baseband unit **1722,** *e.g.* when the cellular base station **1700** is undergoing maintenance, (b) a fixed time period, *e.g.* three months, has passed after the last resistance calculation of the power cable **1736,** (c) the weather dramatically changes, *e.g.* hot weather versus cold weather, (d) the remote radio head **1724** detects that its input voltage is in an overvoltage or under voltage condition, and/or (e) initiated by the operator of the cellular base station **1700.**

Different embodiments for block **1903,** determining the resistance of the power cable **1736,** will be illustrated. These embodiments may also include corresponding embodiments for block **1901,** determining configuration data used for determining the resistance of the power cable **1736.**

In one embodiment, a time-correlated voltage measurement method is used. In this embodiment, the configuration data used in block **1901** are (i) a fixed output voltage of the programmable power supply **1627,** or (ii) a desired voltage on the power cable **1736** proximate to the remote radio head **1724,** and an estimated or prior measured resistance of the power cable **1736.** Further, an additional parameter, a time window, is also stored with the configuration data.

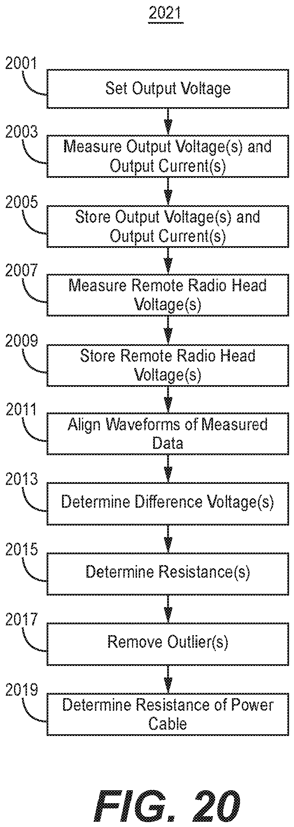

**FIG. 20** is a flow chart **2021** illustrating operations of time correlation methods of determining the resistance of the power cable **1736** according to yet further embodiments of the present invention. This technique can be used during either normal operation or maintenance on the cellular base station **1700.** More particularly, **FIG. 20** illustrates one embodiment of block **1903.**

In block **2001,** set an output voltage, *e.g.* the voltage at the output **1656** of the programmable power supply **1627.** In another embodiment, the output voltage is fixed based upon the fixed output voltage stored in the configuration data. In a further embodiment, the output voltage is calculated by first measuring the current at the output **1656** of the programmable power supply **1627,** multiplying the measured current by the estimated or prior measured resistance of the power cable **1736** to determine an estimated voltage drop on the power cable **1736,** and subtracting the estimated voltage drop from the desired voltage on the power cable **1736** proximate to the remote radio head **1724.**

Optionally, in block **2003,** measure the output voltage, *e.g.* with the voltage sensor **1670,** and the output current, *e.g.* with the current sensor **1658.** In another embodiment, in block **2005,** store the measured output current, e.g. in the power supply current(s) database **1843.** In a further embodiment, also store the measured output voltage, *e.g.* in the power supply voltage(s) database **1841.**

In one embodiment, also store the time, *e.g.* respectively in the power supply voltage(s) database **1841** and the power supply current(s) database **1843,** when the output voltage and output current were measured. In another embodiment, the time is measured by the first clock **1645.** Optionally, measure the output voltage and output current at the same time, relating them to one another, *e.g.* with a timing index, but without storing a measurement time.

In block **2007,** measure a remote radio head voltage, *i.e.* the voltage on the power cable **1736** proximate to the remote radio head **1724;** receive the remote radio head voltage, *e.g.* at a processing system **1897.** In block **2009,** store the remote radio head voltage, *e.g.* in the remote radio head voltage(s) database **1845.** In one embodiment, also store the time, *e.g.* in the remote radio head voltage(s) database **1845,** when the remote radio head voltage was measured. In another embodiment, the time is measured by the second clock **1747.** In a further embodiment, output voltage and remote radio head voltage are measured at the same time.

In one embodiment, more than one output current and remote radio head voltage are measured and stored during the time window. In another embodiment, each measurement time is stored with each measurement. In a further embodiment, the output voltage and remote radio head voltage are measured synchronously, *i.e.* at the same times. In yet another embodiment, storage of the remote radio head voltage(s) and/or time(s) includes transmitting the remote radio head voltage(s) and/or time(s), *e.g.* to an internal processing system 1665 or an external processing system **1729.**

In one embodiment, in block **2011,** *e.g.* when more than one measurement, *e.g.* of output current and remote radio head voltage, is made during the same time window, align the waveforms of measured data (or data generated from such measured data such as difference voltages which is the difference between the output voltage of the programmable power supply and each of the measured remote radio head voltages). Such alignment can preclude the need to store a measurement time for the measurement data. In another embodiment, if the measurement data cannot be aligned because the sampling is too coarse, interpolation can be performed on the one or more sets of measurement data.

In one embodiment, when the output voltage is fixed, align the measured output current and the remote radio head voltage waveforms. In another embodiment, the waveforms are aligned by matching remote radio head voltage maxima and output current minima, and visa versa.

In one embodiment, when the output voltage is not fixed, align the output voltage and the remote radio head voltage waveforms. In another embodiment, the waveforms are aligned by matching remote radio head voltage maxima and minima respectively with the output voltage maxima and minima. In a further embodiment the waveforms are aligned by computing a time correlation between them. In yet another embodiment, if measurement time is recorded for the measured output current and output voltage, or these measurements are otherwise synchronized or indexed so that corresponding output current and voltage for the same time are identifiable, there is no need for aligning the output current. Techniques for matching maxima and minima are further disclosed in U.S. Patent Serial No. 4,745,562, which is incorporated by reference herein in its entirety. In yet another embodiment, waveforms are aligned pursuant to the techniques illustrated in McGill et al., "High-Resolution Alignment of Sampled Waveforms," IEEE Transactions on Biomedical Engineering, vol. BME-31, No. 6, June 1984, pp. 462-468, which is incorporated by reference herein in its entirety.

In block **2013,** determine the difference between each output voltage and measured remote radio head voltage, e.g. for each measured remote radio head voltage. In block **2015,** determine the resistances of the power cable **1736** by dividing each determined difference by a measured current corresponding in time with the measured remote radio head voltage used to determine the difference. Such correspondence in time may be based on alignment or stored measurement times. Corresponding in time means at the same time or at a delayed time where a time delay is substantially created by the power cable 1736.

In one embodiment, block **2017,** identify and remove any determined resistances that are outliers, e.g. more then one standard deviation from the mean of the determined resistances. In block **2019,** determine the resistance of the power cable **1736** by averaging the determined resistances, *e.g.* with or without outliers removed. The resistance value of the power cable is then stored as described in block 1905.

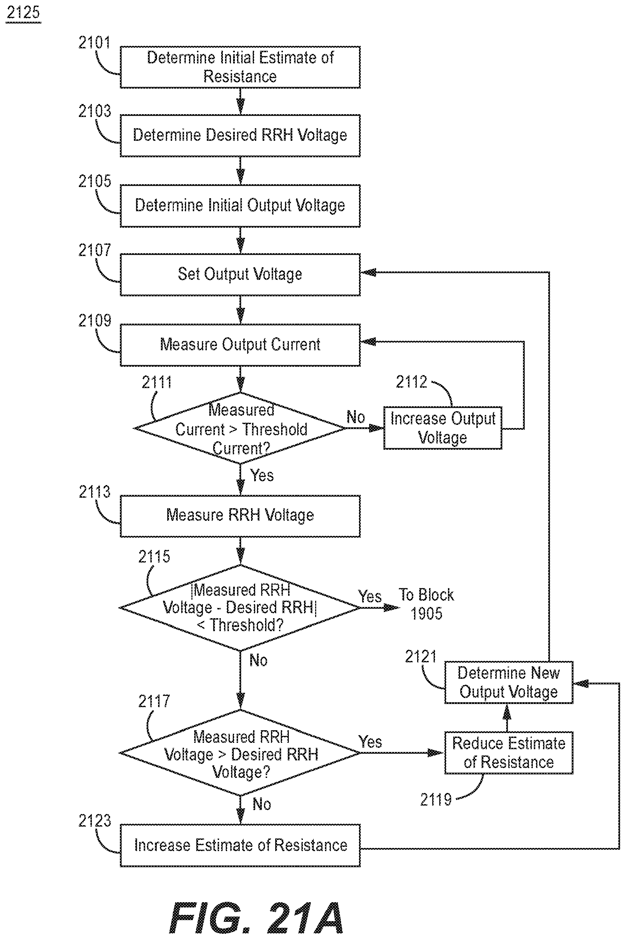

**FIG. 21A** is a flow chart 2125 illustrating operations of iterative methods of determining the resistance of the power cable **1736** according to yet further embodiments of the present invention. This technique can be used during normal operation or during maintenance of the cellular base station **1700.** In one embodiment, the technique illustrated in **FIG. 21A** is performed when the remote radio head **1724** is powering up; during this period the voltage and current waveforms are expected to be relatively smooth with relatively few transients.

More particularly, **FIG. 20** illustrates one embodiment of block **1903.** In this embodiment, the programmable power supply **1627** dynamically adjusts its output voltage based while iteratively determining the resistance of the power cable **1736.** In one embodiment, the current provided by the programmable power supply **1727,** may vary over time depending upon the requirements of the remote radio head **1724.**

In block **2101,** determine an initial estimate of the resistance of the power cable **1736.** In one embodiment, the initial estimate is zero ohms. In one embodiment, the initial estimate is stored in the configuration database **1851.** In another embodiment, the initial estimate is stored in the cable resistance(s) database **1847**.

In block **2103**, determine the desired remote radio head (RRH) voltage, *i.e.* the desired voltage on the power cable **1736** proximate to the remote radio head **1724**. In one embodiment, the desired remote radio head voltage can be at or just below the specified maximum acceptable remote radio head voltage. In another embodiment, the desired remote radio head voltage is stored in the configuration database 1851.

In block **2105**, determine the initial voltage (initial output voltage) at the output **1656** of the programmable power supply **1627**. In one embodiment, the initial voltage equals the desired remote radio head voltage. In another embodiment, the initial voltage is stored in the configuration database **1851**.

In block **2107**, set the output voltage, *e.g.* to the initial output voltage on the programmable power supply **1627**. In block **2109**, measure current, *e.g.* at the output **1656** of the programmable power supply **1627**. In block **2111**, determine if the measured current is greater than a threshold current, *e.g.* a low current level. If the measured current is not greater than the threshold current, then in block **2112** increase the output voltage, if possible, *e.g.* by an incremental voltage specified in the configuration database **1851**, and return to block **2109**. If the current level is greater than the threshold current, then in block **2113**, measure the remote radio head voltage, *i.e.* the voltage on the power cable **1736** proximate to the remote radio head **1724**; receive the remote radio head voltage, *e.g.* at a processing system **1897**.

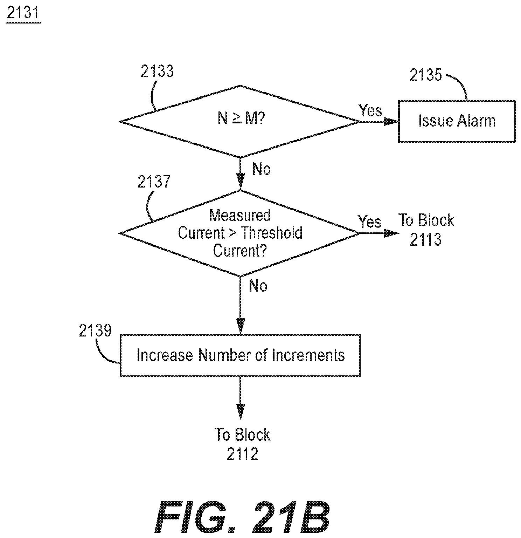

**Fig. 21B** is a flow chart **2131** illustrating operations of methods of determining if the current level is greater than a threshold current **2111** according to yet further embodiments of the present invention. In one embodiment, the output voltage is only increased a finite number of increments or upon the output voltage reaching or exceeding a maximum voltage (because the current is not greater than the low threshold) before the process of determining power cable resistance is halted and an alarm is issued, *e.g.* indicating that the remote radio head **1724** may not be functioning properly. In block **2133**, determine if the number of increments or output voltage (N) is greater than or equal to a target level (M) of respectively number of increments or output voltage. In another embodiment, the target level (M) is stored in the configuration database **1851**.

If the actual number of increments or output voltage is greater than or equal to the target level, then in block **2135** issue an alarm. If the number of increments or output voltage is not greater than or equal to the target level, then proceed to block **2137**. In block 2137, determine if the measured current is greater than the threshold current. If the measured current is greater than the threshold current, then proceed to block **2113**. If the measured current is not greater than the threshold current, then (a) if N is the actual number of increments, proceed to block **2139** or (b) if N is the output voltage, proceed to block **2112**. In block **2139**, increase the number of increments, e.g. by one, and proceed to block **2112**.

In block **2115**, determine, or calculate, if the absolute value of the difference between the measured remote radio head voltage and the desired remote radio head voltage is less than a threshold value or threshold voltage. In one embodiment, the threshold value is stored in the configuration database. If the absolute value of the difference is less then the threshold, then, in block **1905**, store the last determined estimate of the resistance of the power cable **1736**, *e.g.* in the cable resistance(s) database **1847**.

If the absolute value of the difference is greater then the threshold, then, in block **2117**, determine if the measured remote radio head voltage is greater than the desired remote radio head voltage. If the measured remote radio head voltage is greater than the desired remote radio head voltage, then, in block **2119**, decrease the estimated resistance of the power cable **1736**, *e.g.* by an incremental resistance stored in the configuration database **1851**, or by an incremental resistance with a magnitude proportional to the magnitude of the difference between the measured remote radio head voltage and the desired remote radio head voltage. Then, in block **2121**, determine, or calculate, a new output voltage at the output **1656** of the programmable power supply **1627** by multiplying the newly estimated resistance by the measured current, and add the resulting product to the desired remote radio head voltage. Then, return to block **2107**.

If the measured remote radio head voltage is less than the desired remote radio head, then in block **2123**, increase the estimated resistance of the power cable **1736**, *e.g.* by an incremental resistance stored in the configuration database **1851**, or by an incremental resistance with a magnitude proportional to the magnitude of the difference between the measured remote radio head voltage and the desired remote radio head voltage. Then, go to block **2121**.

In one embodiment, if the output current is varying significantly during determination of the resistance of the power cable **1736**, then measure more then one sample of the remote radio head voltage during a time window, and average the measured remote radio head voltages measure during the time window. In another embodiment, the configuration data comprises the initial estimate of resistance, the desired remote radio head voltage, the initial output voltage of the programmable power supply, the incremental resistance, and/or the incremental voltage.

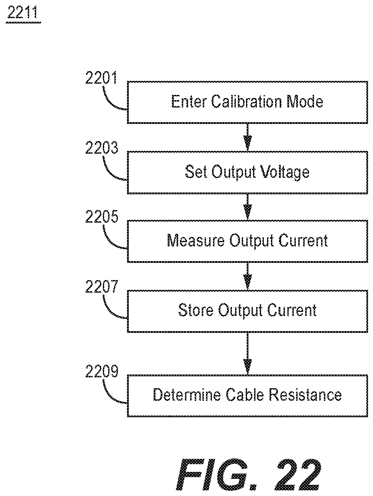

**FIG. 22** is a flow chart 2211 illustrating operations of bypass methods of determining the resistance of the power cable **1736** according to yet further embodiments of the present invention. This technique can be used during maintenance of the cellular base station **1700**. More particularly, **FIG. 22** illustrates one embodiment of block **1903**.

In block **2201**, enter calibration mode, *i.e.* by coupling together the two conductors **1736a, 1736b** of the power cable **1736**. In one embodiment, this is accomplished by the bypass circuit **1749**. The two conductors **1736a, 1736b** can be coupled together directly, *i.e.* shorted, or through an impedance such as a resistor. Such techniques are further described above.

In block **2203,** set a DC or AC output voltage, *e.g.* at the programmable power supply **1727,** *i.e.* at a fixed voltage. In block **2205,** measure the respective DC or AC output current, *e.g.* provided by the programmable power supply **1727.** In one embodiment, also measure the respective DC or AC output voltage, *e.g.* of the programmable power supply **1727.**

In block **2207,** store the output current, *e.g.* in the power supply current(s) database **1843.** In block **2209,** determine the resistance of the power cable **1736.** In one embodiment, the resistance is determined as follows. Determine a quotient by dividing the output voltage by the output current. Then, determine a difference by subtracting a known resistance of the termination at the end of the power cable **1736,** *e.g.* the bypass circuit, *e.g.* stored in the configuration data. Then, divide the difference by a factor, *e.g.* two if the two conductors have of equivalent lengths and cross sections. In another embodiment, the resistance of the bypass circuit 1749, when isolating the power cable 1736 from the remote radio head 1724, is measured, stored in the configuration data.

Embodiments of the present invention provide power supplies for powering radio equipment such as a remote radio head that is located remote from the power supply used to power the radio (e.g., the power supply is at the base of a cellular tower and the radio is at the top of the tower) without receiving any feedback from the radio or from other equipment at the remote location. The voltage of the DC power signal supplied by the power supply to the radio over a cabling connection may be controlled to be at a pre-selected level or within a pre-selected range. The pre-selected level or range may be set to reduce or minimize power losses that may be incurred in transmitting the DC power signal over the cabling connection. The voltage of the DC power signal output by the power supply may be varied based on variations in the current drawn from the power supply so that the voltage of the DC power signal at the radio end of the cabling connection may have, for example, a substantially constant value. This value may be selected to be near a maximum value for the voltage of the DC power signal that may be input to the remote radio head.

While typically the voltage of the DC power signal output by the power supply will be adjusted to maintain the voltage of the DC power signal at the radio end of the cabling connection at a set level, it will be appreciated that some variation is to be expected because of the time it takes the DC power supply to adjust the voltage of the DC power signal in response to changes in the current drawn. It will also be appreciated that the voltage of the DC power signal need not be maintained at a constant level at the radio end of the cabling connection but, may instead have different characteristics (e.g., set to be maintained within a predetermined range, set to return to a pre-selected level within a certain time period, etc.) in some embodiments.

In some current cellular systems, the voltage drop that occurs on the DC power signal that is delivered from a power supply located at the bottom of a cellular tower to the remote radio head at the top of the tower may be so large that the voltage of the DC power signal at the top of the tower may be insufficient to run the remote radio head. As a result, larger diameter power cables are used in some cases that exhibit less DC resistance and hence a smaller voltage drop. However, the use of larger power cables has a number of disadvantages, as these cables can be significantly more expensive, add more weight to the tower (requiring that the towers be constructed to handle this additional weight) and more difficult to install.

Pursuant to embodiments of the present invention, this problem may be reduced or solved by controlling the voltage of the DC power signal output by the power supply so that the voltage of the DC power signal at the radio end of the power cabling connection may be at or near a maximum voltage for the DC power signal that may be input to the remote radio head. This scheme reduces the voltage drop of the DC power signal, and hence may allow for the use of smaller diameter power cables and/or longer cabling connections between the power supply and the remote radio head. Additionally, as noted above, as the power losses experienced by the DC power signal are less, the costs of operating the remote radio head may also be reduced.

As discussed above with reference to **FIG. 4,** in some embodiments of the present invention, the resistance of the power cabling connection between the power supply **28** at the bottom of the tower **30** and the remote radio head **24'** at the top of the tower **30** may be measured or otherwise determined. This measured resistance is then used to set the voltage of the power supply signal output by the second power supply **28** in order to maintain the voltage of the power supply signal that is supplied to the remote radio head **24'** at the top of the tower **30** at a relatively constant value despite variation in the current drawn by the remote radio head **24'.**

In some embodiments, the resistance of the power cabling connection may be determined by sending two signals over the power cabling connection that have different voltages, and then measuring the current of these signals. So long as the power drawn by the remote radio head remains constant during the time that the two signals are transmitted, then the resistance of the power cabling connection may be calculated using known relationships between voltage, current, resistance and power.

In particular, based on Equations (1) and (2) above, the voltage of a first power signal output from the power supply ($V_{PS1}$) relates to the current flowing through the power cabling connection ($I_1$) and the resistance $R_{Cable}$ of the power cabling connection as follows:

$$V_{PS1} = V_{RRH1} + V_{Drop1} = V_{RRH1} + I_1 * R_{Cable} \qquad (5)$$

where $V_{RRH1}$ is the voltage of the first power signal as received at the remote radio head, and where $V_{Drop1}$ is the voltage drop experienced by the first power signal in traversing the power cabling connection to the remote radio head.

As noted above, it is assumed that the power (P) that is drawn by the remote radio head remains constant. The relationship between the voltage of the first power signal at the remote radio head and the power (P) drawn by the remote radio head is as follows:

$$V_{RRH1} = P/I_1 \qquad (6)$$

Combining Equations (5) and (6), the voltage of the first power signal output from the power supply ($V_{PS1}$) is as follows:

$$V_{PS1} = P/I_1 + I_1 * R_{Cable} \qquad (7)$$

Solving Equation (7) for the power (P):

$$V_{PS1} - I_1 * R_{Cable} = P/I_1 \qquad (8)$$

$$P = (V_{PS1} * I_1) - (R_{Cable} * I_1^2) \qquad (9)$$

In Equation (9), $V_{PS1}$ is known (as the voltage of the first power signal may be set to a predetermined value), and the value of $I_1$ is measured using, for example, a current sensor in the power supply. The values of P and $R_{Cable}$, however, may not be known.

As noted above, a second power signal ($V_{PS2}$) may then be output from the power supply and the current ($I_2$) of this second power signal is measured. Combining Equations (5) and (6) above with respect to the second power signal, the voltage thereof may be determined as follows:

$$V_{PS2} = P/I_2 + I_2 * R_{Cable} \qquad (10)$$

As noted above, if the power (P) drawn by the remote radio head remains constant, then P is the same in Equations (9) and (10). Accordingly incorporating Equation (9) into Equation (10) for the power (P):

$$V_{PS2} = [(V_{PS1} * I_1) - (R_{Cable} * I_1^2)]/I_2 + I_2 * R_{Cable} \qquad (11)$$

Solving Equation (11) for $R_{Cable}$:

$$V_{PS2} * I_2 = V_{PS1} * I_1 - R_{Cable} * I_1^2 + I_2^2 * R_{Cable} \qquad (12)$$

$$V_{PS2} * I_2 - V_{PS1} * I_1 = R_{Cable}(I_1^2 + I_2^2) \qquad (13)$$

$$R_{Cable} = (V_{PS2} * I_2 - V_{PS1} * I_1)/(I_1^2 + I_2^2) \qquad (14)$$

Thus, so long as the power (P) drawn by the remote radio head remains constant, by sending two power signals having different voltages (namely $V_{PS1}$ and $V_{PS2}$) from the power supply and measuring the current of these signals (namely ($I_1$ and $I_2$), Equation (14) may be used to determine the resistance $R_{Cable}$ of the power cabling connection.

In order to reduce the likelihood that the power (P) drawn by the remote radio head changes between the times that the first power signal and the second power signal are injected onto the power cabling connection, the first and second power signals may be transmitted with little delay there between. As the currents $I_1$ and $I_2$ can be measured very quickly, it may be possible to send the first and second power signals and measure the currents thereof within a very short timeframe such as, for example, a millisecond or even less. Moreover, in some embodiments, the system may be programmed to transmit more than two power signals having different voltages to the remote radio head and measuring the associated currents of these signals in order to either (1) identify and discard power signals that were transmitted during a time when the power (P) drawn by the remote radio head changed or (2) reduce the impact of any such measurements that are made when the power drawn by the remote radio head changed by averaging those measurements with a large number of measurements that were taken at times when the power drawn by the remote radio head did not change.

In some embodiments, the resistance $R_{Cable}$ of the power cabling connection may be calculated using a running average of the voltages and measured currents of a series of power signals that are transmitted over the power cabling connection. For example, if a total of X power signals having different voltages are transmitted over the power cabling connection, the resistance $R_{Cable}$ of the power cabling connection may be determined as follows:

$$R_{Cable} = \Sigma \ (V_{PSn+1}*I_{n+1} - V_{PSn}*I_n)/(I_{n+1}^2 + I_n^2)]/X \qquad (15)$$

where the summation is performed from n=1 to (X - 1).

The resistance $R_{Cable}$ of the power cabling connection may change over time based on a number of factors such as, for example, changes in the ambient temperature, variation in the current drawn (which can affect the temperature), corrosion on the power cable or connectors, and various other factors. These changes, however, tend to not be large and tend to occur gradually over time. By way of example, the resistance of copper changes at a rate of about 0.4% for each change in temperature by one degree Celsius. Thus, if over the course of a day the temperature changes from 80 °F (26.7 °C) to 50 °F (10 °C), the resistance of the power cabling connection may change by nearly 7%. However, for resistance measurements obtained using the above-described techniques that are taken on the order of seconds (or less) apart, the change in resistance due to temperature changes will be almost zero.

In some embodiments, the resistance $R_{Cable}$ of the power cabling connection may be determined using Equation (15) above where "X" is set to a relatively large number (e.g., 100, 1000, etc.). Herein, the elements of the summation in Equation (15) for each different value of "n" may be referred to as a "sample." Using as an example the case where X is set to 500, the voltage of the power supply signal output by the power supply may be varied 500 times and the resistance corresponding to each different voltage may then be measured. By way of example, if at the start of the resistance measurement procedure the power supply is outputting a power supply signal having a voltage of 58 Volts so as to provide a power signal at the input of the remote radio head having a desired voltage (e.g., between 54-56 Volts), during the resistance measurement the voltage of the power supply signal might be toggled every 10 milliseconds between 58 Volts and 57.5 Volts. In this case, the summation in Equation (15) would have 499 samples, and assuming that the current drawn by the remote radio head does not change, each of these samples should theoretically have the same value, although, measurement error, noise, changes in temperature and the like will in practice introduce a small amount of variation. After the 499 samples included in the summation of Equation (15) in this example are determined, they may be reviewed and any sample that appears as an outlier may be discarded, as the outliers are likely associated with a change in the power drawn by the remote radio head. The outliers may be particularly easy to identify as they may tend to occur in consecutive locations in the summation if the voltage of the power supply single is toggled at an appropriate rate.

In the above approach, any appropriate technique may be used for identifying and discarding outliers among the samples summed in Equation (15). In one embodiment, samples that vary by more than a predetermined amount from, for example, an average value may be discarded. In another embodiment, samples that vary by more than a predetermined percentage from an average or median value of a large group of samples that all have approximately the same value may be discarded. Many other algorithms or techniques may be used. In this fashion, distortions that might otherwise be introduced in the resistance calculation can be avoided or at least reduced.

By way of example, after computing the 499 samples in the above-described embodiment, a median value of the 499 samples may be determined. Ones of the 499 samples that deviated from the median sample by more than a pre-determined amount such as, for example, a pre-selected percentage (e.g., 5%), might then be discarded. The remaining samples may then be summed to determine the resistance of the power cabling connection.

In other embodiments, the resistance $R_{Cable}$ of the power cabling connection may be determined using Equation (15), even though some error may be introduced by samples taken during periods when the power drawn by the load changed. This approach will introduce some amount of error, although the degree of error may be reduced by performing the resistance calculation more often and/or by using larger numbers of samples.

One advantage of the above-described approaches for determining the resistance $R_{Cable}$ of the power cabling connection is that it allows calculation of the resistance during normal operation by simply toggling or otherwise adjusting the voltage of the power supply signal a small amount during normal operation. The amount of the voltage swing may be selected based on a variety of different factors. Moreover, while in the above examples the voltage is toggled between two different values, it will be appreciated that more than two values may be used.

It should also be noted that an initialization procedure may be used when the cellular base station first goes operational, as initially the appropriate voltage level for the power supply signal may not be known. In this case, a relatively low power supply voltage may be used that is less than the maximum operating voltage of the remote radio head to ensure that a power supply signal having too large a voltage level is not supplied to the remote radio head. Once a resistance measurement has been performed, the voltage levels of the power supply signal may be increased by an appropriate amount in view of the measured resistance and the loading of the remote radio head.

One or more of the techniques for determining the resistance of the power cabling connection that are described above may then be performed on a periodic or non-periodic basis. In this manner, changes in the resistance of the power cabling connection may be identified and the voltage of the power supply signal may be adjusted accordingly. Between a hot summer day and a cold winter night the temperature might vary by as much as 100 °F (55 °C), which corresponds to more than a 20% change in the resistance of the power cabling connection. By adjusting the power supply voltage to account for such changes in the resistance, the current of the power supply signal may be reduced by a corresponding amount, which may result in significant power savings since the power loss due to the voltage drop varies according to the square of the current.

In some embodiments, the power supply **150** of **FIG.** 5 may be used to measure the resistance based on the above-described techniques. The control logic 162 may toggle the voltage of the power signal output by the power supply 150 in the manner described above, and the current sensor 158 may sense the current of the power signal associated with each different voltage value. The control logic **162** may identify and discard outlying samples using, for example, one of the techniques discussed above, and may determine the resistance of the power cabling connection according to Equation (15).

One potential problem with setting the voltage of the power supply signal that is output by the power supply to a voltage that will result in the power supply signal having a voltage at the remote radio head that is near the maximum specified voltage that the remote radio head may handle is the possibility that power supply signal that is input to the remote radio head may occasionally have a voltage that exceeds the maximum specified power supply voltage for the remote radio head. This may occur, for example, if there is a sudden decrease in the amount of traffic supported by the remote radio head, which will in turn result in a sudden decrease in the current drawn by the remote radio head. This sudden drop in current may significantly reduce the voltage drop along the power cabling connection, thereby increasing the voltage of the power signal received at the remote radio head. While the power supplies according to embodiments of the present invention are designed to adjust the voltage of the power supply signal to compensate for this drop in current, if the voltage of the power supply signal is not adjusted quickly enough, the reduction in the voltage drop may result in the power supply signal at the remote radio head having a voltage that exceeds the maximum specified power signal voltage for the remote radio head. As this may damage the remote radio head, suitable margins may be built into the system to protect the remote radio heads from such possible damage.

Moreover, rapid changes in the current flowing through the power cable may also result in a temporary change in the voltage of the power signal due to the inductance of the cable. When the current of the power signal is rapidly increased, this may result in a phenomena known as the dI/dt voltage drop, which may be determined as follows:

$$V_{dI/dt\ Drop} = L*(dI/dt) \tag{16}$$

where L is the cumulative inductance of the conductors and dI/dt is the rate of increase in the current flowing through the conductors with respect to time. When the the current of the power signal is rapidly decreased, the reverse process happens, which may result in a temporary increase in the voltage of the power signal, which is referred to herein as a "dI/dt voltage spike."

Pursuant to further embodiments of the present invention, a shunt capacitance unit may be provided between the two conductors of a power cable that is used to provide a DC power signal to a remote radio head. This shunt capacitance unit may be implemented, for example, using one or more capacitors that are coupled between the power supply and return conductors of the power cable. The shunt capacitance unit may dampen increases in the voltage of the power signal that result from changes in the current drawn by the remote radio head and by the above-discussed dI/dt voltage spikes. As such, a sudden decrease in the current level of the power signal due to a sudden drop in the loading of the remote radio head may result in a smaller and slower reduction in the voltage drop, and hence the shunt capacitance unit may help protect the remote radio head from situations where the current of the power signal drops more quickly than the voltage of the power signal output by the power supply can be adjusted.

By way of example, a remote radio head that is located atop a large antenna tower may specify a maximum voltage of 58 Volts for the power signal. Pursuant to embodiments of the present invention, the voltage of the power signal at the output of the power supply (which is located at the bottom of the tower) that is used to power this remote radio head may be adjusted so that the power signal at the input to the remote radio head has a voltage of approximately 55 Volts. In situations where the remote radio head is drawing a large amount of current, the power supply may output a power signal having a voltage of, for example, 62 volts in order to supply a power signal having 55 Volts to the remote radio head due to the large $I^2R$ power loss along the power cabling connection between the power supply and the remote radio head. If all of the traffic to the remote radio head suddenly drops, the current drawn by the remote radio head will decrease in a dramatic fashion, as will the $I^2R$ power loss along the power cabling connection. As a result, the voltage of the power signal that is delivered to the remote radio head may be on the order of 60 Volts or more if the power supply fails to adjust the output voltage quickly enough, and this 60 Volt power signal may potentially damage electronics in the remote radio head.

**FIG. 10** is a schematic diagram that illustrates a trunk cable assembly **500** that may used, for example, to implement the trunk cable **40** of a cellular base station. The trunk cable assembly **500** includes nine individual power cables and nine sets of four optical fibers, and hence is suitable for transmitting power and data to a cellular base station that includes nine remote radio heads. As an example, if the cellular base station **100** of **FIG. 3** were modified to include nine baseband units **22,** remote radio heads **24** and twenty-seven antennas **32,** then the trunk cable **500** of **FIG. 10** would be a suitable replacement for the trunk cable **40** illustrated in **FIG. 3.** The trunk cable **500** includes shunt capacitances between the two conductors of each of the nine power cables that are used to provide DC power signals to the nine remote radio heads **24.** These shunt capacitances may dampen increases in the voltage of the DC power signals that may result from changes in the current drawn by the remote radio head and by associated dI/dt voltage spikes in order to protect the remote radio heads from overshooting the maximum specified voltage for the power signal input thereto.

As shown in **FIG. 10,** the trunk cable assembly **500** comprises a hybrid power/fiber optic cable **510,** a first breakout canister **530** and a second breakout canister **550.** The hybrid power/fiber optic cable **510** has nine individual power cables **512** (the callout in **FIG. 10** depicts three of these individual power cables **512**) that may be grouped together into a composite power cable **518** and a fiber optic cable **520** that includes thirty-six optical fibers **522.** The fiber optic cable **520** may comprise a jacketed or unjacketed fiber optic cable of any appropriate conventional design. The composite power cable **518** and the fiber optic cable **520** may be enclosed in a jacket **524.** While one example hybrid power/fiber optic cable **510** is shown in **FIG. 10,** it will be appreciated that any conventional hybrid power/fiber optic cable may be used, and that the cable may have more or fewer power cables and/or optical fibers. An exemplary hybrid power/fiber optic cable is the HTC-24SM-1206-618-APV cable, available from CommScope, Inc. (Hickory, North Carolina).

The first breakout canister **530** comprises a body **532** and a cover **536.** The body **532** includes a hollow stem **534** at one end that receives the hybrid power/fiber optic cable **510,** and a cylindrical receptacle at the opposite end. The cover **536** is mounted on the cylindrical receptacle to form the breakout canister **530** having an open interior. The hybrid power/fiber optic cable **510** enters the body **532** through the stem **534.** The composite power cable **518** is broken out into the nine individual power cables **512** within the first breakout canister **530.** Each individual power cable **512** includes a power supply conductor **514** and a return conductor **516.** The nine individual power cables **512** are routed through respective sockets **538** in the cover **536,** where they are received within respective protective conduits **540** such as a nylon conduit that may be sufficiently hardy to resist damage from birds. Thus, each individual power cable **512** extends from the first breakout canister **530** within a respective protective conduit **540.** The optical fibers **522** are maintained as a single group and are routed through a specific socket **538** on the cover **536,** where they are inserted as a group into a conduit **542.** Thus, the first breakout canister **530** is used to singulated the nine power cables **512** of composite power cable **518** into individual power cables **512** that may be run to respective remote radio heads **24,** while passing all of the optical fibers **522** to a separate breakout canister **550.**

As shown in the inset of **FIG. 10,** a plurality of shunt capacitance units in the form of ceramic capacitors **548** are provided within the first breakout canister **530.** Each capacitor **548** is connected between the power supply conductor **514** and the return conductor **516** of a respective one of the individual power cables **512.** For low frequency signals such as a DC power signal, the shunt capacitors **548** appear as an open circuit, and thus the DC power signal that is carried on each individual power cable **512** will pass by the respective shunt capacitors **548** to the remote radio heads **24.** However, as discussed above, during periods where the current carried by an individual power cable **512** drops in response to a decreased loading at the remote radio head **24,** the shunt capacitor **548** may act to reduce the magnitude of the dI/dt voltage spike on the DC power signal.

As noted above, the optical fibers **522** pass through the first breakout canister **530** as a single unit in conduit **542** which connects to the second breakout canister **550.** In the second breakout canister **550,** the thirty-six optical fibers **522** are separated into nine optical fiber subgroups **552.** The optical fiber subgroups **552** are each protected within a respective conduit **554.** The second breakout canister **550** may be similar to the first breakout canister **530** except that it is used to break out the thirty-six optical fibers **522** into nine sets of four optical fibers that are fed into nine respective protective conduits **552.**

As discussed above, rapid changes in the power drawn by a remote radio head **24** may result in an increase in the voltage of the power signal received at the remote radio head **24** because (1) the power supply **28** requires some amount of time to sense the reduction in current drawn by the remote radio head **24** and to adjust the voltage of the power supply signal in response thereto and (2) a sudden decrease in the current drawn by the remote radio head **24** may result in a dI/dt voltage spike that momentarily increases the voltage of the power signal at the input to the remote radio head **24.** By providing power cables such as the hybrid power/fiber optic cable assembly **500** of **FIG. 10** that have shunt capacitors **548** integrated into each individual power cable **512,** it is possible to dampen such increases in the voltage of the power signal received at the remote radio head **24,** thereby protecting the remote radio head **24** from unintended spikes in the voltage of the power signal that exceed the maximum voltage for the power signal that is specified for the remote radio head.

Those of skill in this art will appreciate that the shunt capacitances **548** may be provided in any number of forms. For example, a shunt capacitance unit may be in the form of individual components, such as one or more capacitors, or in the form of other physical structures such as parallel conductors separated by an air gap that may act like a capacitor. The amount of shunt capacitance provided may vary depending on a number of factors including, for example, how close the voltage of the power signal that is input to the remote radio head **24** is to the maximum specified power signal voltage for the remote radio head **24.** Generally speaking, the amount of shunt capacitance may be on the order of hundreds, thousands, tens of thousands, or hundreds of thousands of microfarads in some embodiments.

The use of shunt capacitance units is disclosed in U.S. Patent Application Publication No. 2015/0080055 ("the '055 publication"), which is hereby incorporated by reference in its entirety, although primarily for purposes of dampening a dI/dt voltage drop that may occur in response to sharp increases in the current drawn by a remote radio head. As discussed above, it has been discovered that the use of such a shunt capacitance unit may also be used to protect the remote radio head from situations in which the voltage of the power signal would exceed the maximum power supply voltage specified for the remote radio head by slowing the decrease in the voltage drop and thereby providing the power supply additional time to adjust to the reduced loading at the remote radio head. The '055 publication discloses a variety of ways in which the shunt capacitance unit may be implemented, all of which may be used according to embodiments of the present invention to protect a remote radio head from situations where the voltage of the power signal that is delivered to the remote radio head could overshoot the maximum specified voltage for the remote radio head. The entire content of the '055 publication is incorporated herein by reference in its entirety.

It will also be appreciated that the shunt capacitance units may be placed in a variety of locations other than within a trunk cable as shown in the embodiment of **FIG. 10.** For example, in many cellular base stations, fiber optic and power jumper cables extend between a breakout enclosure of a trunk cable (e.g., the breakout canisters **530, 550** of **FIG. 10**) and the remote radio heads. In some cases, separate power jumper cables and fiber optic jumper cables are provided, while in other cases composite jumper cables that include both optical fibers and power conductors (which are separately connectorized) may be used to connect each remote radio head to the junction enclosure. The jumper cables are much shorter in length than the trunk cables, as the breakout enclosure is typically located only a few feet from the remote radio heads, whereas the trunk cable is routed tens or hundreds of feet up the antenna tower. Additionally, the jumper cables include far fewer components. As such, trunk cables are typically far more expensive than jumper cables.

In some embodiments, the shunt capacitance units may be implemented in the power jumper cables or at other locations near the power inputs to the respective remote radio heads. Implementing the shunt capacitance units in the jumper cables may provide a more efficient and cost-effective way of retrofitting existing cellular base stations to include shunt capacitance units. Additionally, jumper cables may be easily replaced by a technician as they are designed to be connected and disconnected, and jumper cable replacement does not raise environmental sealing concerns as does opening a junction enclosure such as a breakout canister of a trunk cable.

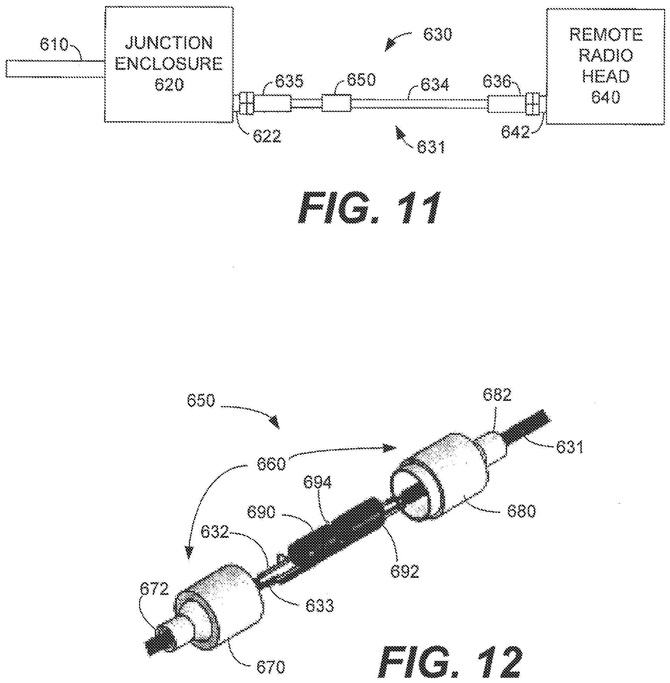

**FIG. 11** is a schematic drawing illustrating how a jumper cable **630** having an associated shunt capacitance unit **650** according to embodiments of the present invention may be used to connect a junction enclosure such as a breakout canister of a trunk cable to a remote radio head. **FIG. 12** is a partially-exploded perspective view of an example embodiment of the shunt capacitance unit **650.** As shown in **FIGS. 11-12,** a trunk cable **610** is terminated into or includes a junction enclosure **620** at, for example, the top of an antenna tower (not shown). The jumper cable **630** connects the junction enclosure **620** to a remote radio head **640.** The jumper cable **630** includes a cable segment **631** that has a power supply conductor **632** and a return conductor **633** that are electrically insulated from each other (see **FIG. 12**). In some embodiments, the power supply conductor **632** and the return conductor **633** may each comprise an insulated 8-gauge to 14-gauge copper or copper alloy wire.

A protective jacket **634** may enclose the power supply and return conductors **632, 633.** First and second connectors **635, 636** are terminated onto either end of the cable segment **631.** The first connector **635** is configured to connect to a mating connector **622** on the junction enclosure **620,** and the second connector **636** is configured to connect to a mating connector **642** of the remote radio head **640.** The connectors **622, 642** may be identical so that either of connectors **635** and **636** may be connected to either of the connectors **622, 642.** The jumper cable **630** may include an associated shunt capacitance unit **650** that may be implemented in a variety of locations.

As shown in **FIG. 12,** the shunt capacitance unit **650** may be implemented as a sealed unit that is interposed along the cable segment **631**. The shunt capacitance unit **650** may have a housing **660** that includes housing pieces **670, 680** that have respective cable apertures **672, 682** that allow the cable segment **631** to pass through the housing **660**. The shunt capacitance **650** is implemented using a pair of electrolytic capacitors **690, 692** that are connected in parallel between the power supply conductor **632** and the return conductor **633**. The capacitors **690, 692** may have a total capacitance of, for example, between 400 and 2500 microfarads.

The capacitors **690, 692** may comprise non-polar electrolytic capacitors and hence the jumper cable **630** may be installed in either direction between the junction enclosure **620** and the remote radio head **640**. A fuse circuit **694** may be provided along the shunt path between the power supply and return conductors **632, 633** that creates an open circuit in the event of failure of the capacitors **690, 692**.

While **FIG. 12** depicts a jumper cable having a shunt capacitance unit **650** implemented along the cable thereof, it will be appreciated that in other embodiments the shunt capacitance unit **650** may be implemented in one of the connectors **635, 636** of the jumper cable **630**. In still other embodiments, the shunt capacitance unit **650** may be implemented as a stand-alone unit that may be connected, for example, between the junction enclosure **620** and a conventional jumper cable or between the remote radio head **640** and a conventional jumper cable.

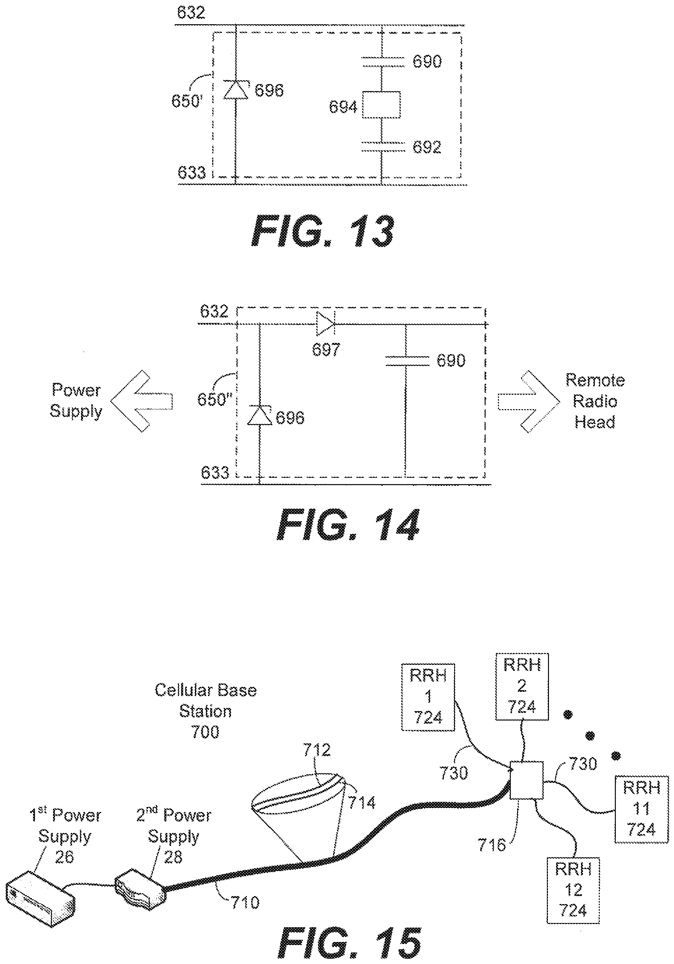

Pursuant to still further embodiments of the present invention, a protection circuit in the form of an avalanche diode may be coupled in parallel with one of the above-described shunt capacitance units **548, 650** that may be implemented along the power cables of a trunk cable, of a jumper cable, or as a standalone unit. **FIG. 13** is a circuit diagram of a shunt capacitance unit **650'** that includes such an avalanche diode. As shown in **FIG. 13,** the shunt capacitance unit **650'** is identical to the shunt capacitance unit **650** of **FIG. 12,** except that the shunt capacitance unit **650'** further includes an avalanche diode **696** that is positioned between the power supply conductor **632** and the return conductor **633** of the jumper cable, in parallel to the capacitors **690, 692**. The diode **696** is designed to be non-conducting under normal operating conditions, but to start conducting at higher reverse bias voltages. For instance, in one example embodiments the diode **696** may be designed to be non-conducting at reverse bias voltages that are at somewhere between 0.5 Volts and 3 Volts less than the maximum specified voltage for the power supply signal that is provided to the remote radio head, but to start conducting at higher reverse bias voltages. It will be appreciated, however, that the avalanche diode **696** may be designed to operate at other voltage margins in other embodiments. The reverse breakdown voltage of the avalanche diode **696** may be selected based on a maximum specified voltage for the power supply signal that is provided to the remote radio head. Thus, if the voltage of the DC power signal at the input to the remote radio head starts to approach the maximum specified power signal voltage for the remote radio head, the avalanche diode **696** experiences reverse breakdown and will provide a bypass current path.

In the embodiment of **FIG. 13,** the diode **696** may be more effective than the capacitors **690, 692** in absorbing voltage spikes to ensure that the voltage of the power supply signal does not exceed the maximum specified power signal voltage for the remote radio head. If the voltage of the power signal spikes above the reverse breakdown voltage of the avalanche diode **696,** the voltage across the diode **696** will be held substantially at the reverse breakdown voltage for the duration of the voltage spike (i.e., until the programmable power supply regulates the voltage). In some embodiments of **FIG. 13,** the shunt capacitors **690, 692** and/or the fuse circuit **694** may be omitted so that the circuit **650'** will simply be a protection circuit without any shunt capacitance.

A diode such as, for example, the avalanche diode **696** that is included in the embodiment of **FIG. 13,** may also be used to measure the resistance of the power cabling connection according to further embodiments of the present invention. In particular, a reverse DC voltage may be applied across the power supply and return conductors **632, 633,** and the reverse current in response to this reverse voltage may be measured using, for example, the resistance measurement circuit **170** of the programmable power supply (see **FIG. 5**). The reverse voltage across the input to the remote radio head will be limited to the forward voltage across the avalanche diode **696,** which will be less than 1 Volt, and hence will not be harmful to the remote radio head. While this measurement cannot be done during normal operation of the remote radio head (as the reverse DC voltage is applied as opposed to the normal power supply signal), this technique may be performed, for example, as part of the qualification of a new cellular base station to measure the resistance of the power cabling connection thereof. It will be appreciated that other types of diodes such as a p-n diode or a Schottky diode may be used in place of the avalanche diode **696** for purposes of making such a resistance measurement. The use of the avalanche diode **696** additionally provides the above-described over-voltage protection feature.

Moreover, as shown in **FIG. 14,** in a further embodiment, a diode **697** may be added in series along the power supply conductor **632** in between the shunt paths for the avalanche diode **696** and the capacitor **690**. Alternatively, diode **697** may be reversed and placed in the corresponding location along return conductor **633**. The capacitor **690** may hold the voltage to the remote radio head for the very short time period necessary to measure the reverse current when the reverse voltage is applied as discussed above. The diode **697** may prevent the capacitor **690** from discharging through resistance measuring circuit during periods when the reverse voltage is applied. Thus, the circuit **650"** of **FIG. 14** may be used to measure the resistance of the power cabling connection during normal operation of the remote radio head by quickly applying the reverse voltage and measuring the reverse current during normal operation. In other embodiments the circuit of **FIG. 14** may further include the fuse circuit **694** and/or the second capacitor **692** that are shown in **FIG. 13.**

**FIG. 15** is a schematic block diagram illustrating selected elements of a cellular base **700** according to further embodiments of the present invention. The cellular base station **700** uses a so-called "power bus" power cable **710** that has a single power supply conductor **712** and a single return conductor **714.** These conductors **712, 714** are typically much larger than the conductors provided in a power cable that includes a separate pair of power supply and return conductors for each remote radio head. The pair of conductors **712, 714** are used to provide power signals to a plurality of remote radio heads **724.** The power bus cable **710** includes a junction enclosure **716,** and individual power jumper cables **730** may be used to connect each remote radio head **724** to the power supply and return conductors **712, 714** of the power bus cable **710.** The power bus cable **710** may be a standalone power cable or may be part of a trunk cable that also includes optical fibers that carry data between the remote radio heads **724** and baseband units (not shown).

The use of power bus power cables such as cable **710** in the cellular base stations according to embodiments of the present invention may have certain advantages. In particular, the current drawn over the power bus cable **710** will be the current required by all of the remote radio heads **724** that are powered over the power bus cable **710.** As state-of-the-art cellular base stations now often have twelve (or more) remote radio heads **724,** the current drawn over the pair of conductors **712, 714** will be the total current drawn by all twelve remote radio heads **724.** Thus, large changes in the current drawn by one of the remote radio heads that would normally require a large adjustment in the output voltage of the power supply signal are smoothed out since any one remote radio head **724** will only be drawing, on average, one twelfth of the current carried over the power bus cable **710.**

While embodiments of the present invention are primarily described above with respect to cellular base stations that have conventional antenna towers, it will be appreciated that the techniques and systems described herein may be applied to a wide variety of other cellular systems. For example, cellular service is often provided in tunnels by locating the baseband equipment and power supply in an enclosure and then connecting this equipment to remote radio heads and antennas via long horizontal trunk cables. Very long cabling connections may be used in some instances, and the voltage drop along the cable may be particularly problematic in such installations. Similarly, in some metrocell architectures, the same concept is applied above-ground, with the remote radio heads and antennas typically mounted on smaller, pre-existing structures such as utility poles, buildings and the like. Once again, the trunk cables connecting the baseband equipment and power supplies to the distributed remote radio heads and antennas may be very long (e.g., a kilometre or more in some cases), and hence voltage drop likewise may be a significant problem. Any of the above-described embodiments of the present invention may be used in these or similar applications.

The present invention has been described with reference to the accompanying drawings, in which certain embodiments of the invention are shown. This invention may, however, be embodied in many different forms and should not be construed as limited to the embodiments that are pictured and described herein; rather, these embodiments are provided so that this disclosure will be thorough and complete, and will fully convey the scope of the invention to those skilled in the art. Like numbers refer to like elements throughout the specification and drawings. It will also be appreciated that the embodiments disclosed above can be combined in any way and/or combination to provide many additional embodiments.

It will be understood that, although the terms first, second, etc. are used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes any and all combinations of one or more of the associated listed items.

Unless otherwise defined, all technical and scientific terms that are used in this disclosure have the same meaning as commonly understood by one of ordinary skill in the art to which this invention belongs. The terminology used in the above description is for the purpose of describing particular embodiments only and is not intended to be limiting of the invention. As used in this disclosure, the singular forms "a", "an" and "the" are intended to include the plural forms as well, unless the context clearly indicates otherwise. It will also be understood that when an element (e.g., a device, circuit, etc.) is referred to as being "connected" or "coupled" to another element, it can be directly connected or coupled to the other element or intervening elements may be present. In contrast, when an element is referred to as being "directly connected" or "directly coupled" to another element, there are no intervening elements present.

In the description above, when multiple units of an element are included in an embodiment, each individual unit may be referred to individually by the reference numeral for the element followed by a dash and the number for the individual unit (e.g., antenna 32-2), while multiple units of the element may be referred to collectively by their base reference numeral (e.g., the antennas 32).

It will be further understood that the terms "comprises" "comprising," "includes" and/or "including" when used herein, specify the presence of stated features, operations, elements, and/or components, but do not preclude the presence or addition of one or more other features, operations, elements, components, and/or groups thereof.

In the drawings and specification, there have been disclosed typical embodiments of the invention and, although specific terms are employed, they are used in a generic and descriptive sense only and not for purposes of limitation, the scope of the invention being set forth in the following claims.

Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims.

**Claims**

1. An apparatus, comprising:
   a processing system (1891) configured to:

   determine configuration data (1901);
   using the configuration data, determine a resistance of a power cable (1903) coupling a programmable power supply to a remote radio head mounted on a mounting structure, comprising:

   determine an initial estimate of the resistance of the power cable (2101);
   determine a desired remote radio head voltage (2103);
   determine an initial output voltage of the programmable power supply (2105);
   set an output voltage of the programmable power supply (2107);
   receive a measured remote radio head voltage;
   determine if an absolute value of a difference between the measured remote radio head voltage and the desired remote radio head voltage is less than a threshold voltage (2115);
   if the absolute value of the difference between the measured remote radio head voltage and the desired remote radio head voltage is not less than the threshold voltage, then determine if the measured remote radio head voltage is greater than the desired remote radio head voltage (2117);
   if the measured remote radio head voltage is greater than the desired remote radio head voltage, then decrease an estimate of the resistance of the power cable (2119);
   if the measured remote radio head voltage is not greater than the desired remote radio head voltage, then increase the estimate of the resistance of the power cable (2123);
   determine a new output voltage of the programmable power supply (2121); and
   store a new estimate of the resistance of the power cable (1905).

2. The apparatus of claim 1, wherein the processing system is further configured to determine whether to again determine the resistance of the power cable (1907).

3. The apparatus of claim 2, wherein determine whether to again determine the resistance of the power cable comprises determine whether to again determine the resistance of the power cable based upon at least one of:

   disablement of the remote radio head, passing of a fixed time period,
   weather changes, and remote radio head detection of an overvoltage or under voltage condition.

4. The apparatus of claim 1, wherein increase the estimate of the resistance comprises increase the estimate of the resistance by an incremental resistance; and wherein decrease the estimate of the resistance comprises decrease the estimate of the resistance by the incremental resistance.

5. The apparatus of claim 1, wherein the processing system is further configured to:

   receive a measurement of an output current of the programmable power supply;
   determine if the output current is greater than zero amps; and
   upon determining that the output current is not greater than zero amps, then increase the output voltage.

6. The apparatus of claim 5, wherein increase the output voltage comprises increase the output voltage by an incremental voltage.

7. The apparatus of claim 1, wherein determine the configuration data comprises obtaining, from a database, at least one of: the initial estimate of the resistance, the desired remote radio head voltage, the initial output voltage of the programmable power supply, an incremental resistance, and an incremental voltage.

8. A method, comprising:

   determining configuration data;
   using the configuration data, determining a resistance of a power cable (1903) coupling a programmable power supply (28, 1627, 1727) to a remote radio head (24') mounted on a mounting structure, comprising:

   determining an initial estimate of the resistance of the power cable (2101);
   determining a desired remote radio head voltage (2103);
   determining an initial output voltage of the programmable power supply (2105);
   setting an output voltage of the programmable power supply (2107);
   receiving a measured remote radio head voltage;
   determining if an absolute value of a difference between the measured remote radio head voltage and the desired remote radio head voltage is less than a threshold voltage (2115);
   if the absolute value of the difference between the measured remote radio head voltage and the desired remote radio head voltage is not less than the threshold voltage, then determining if the measured remote radio head voltage is greater than the desired remote radio head voltage (2117);
   if the measured remote radio head voltage is greater than the desired remote radio head voltage, then decreasing an estimate of the resistance of the power cable (2119);
   if the measured remote radio head voltage is not greater than the desired remote radio head voltage, then increasing the estimate of the resistance of the power cable (2123);
   determining a new output voltage of the programmable power supply (2121); and
   storing a new estimate of the resistance of the power cable (1905).

9. The method of claim 8, further comprising: determining whether to again determine the resistance of the power cable (1907).

10. The method of claim 9, wherein determining whether to again determine the resistance of the power cable comprises determining whether to again determine the resistance of the power cable based upon at least one of: disablement of the remote radio head, passing of a fixed time period, weather changes, and remote radio head detection of an overvoltage or under voltage condition.

11. The method of claim 8, wherein increasing the estimate of the resistance comprises increasing the estimate of the resistance by an incremental resistance; and
   wherein decreasing the estimate of the resistance comprises decreasing the estimate of the resistance by the incremental resistance.

12. The method of claim 8, further comprising:

   measuring an output current of the programmable power supply;
   determining if the output current is greater than zero amps; and
   if the output current is not greater than zero amps, then increasing the output voltage.

13. The method of claim 12, wherein increasing the output voltage comprises increasing the output voltage by an incremental voltage.

14. The method of claim 11, wherein determining the configuration data comprises obtaining, from a database, at least one of: the initial estimate of the resistance, the desired remote radio head voltage, the initial output voltage of the programmable power supply, the incremental resistance, and an incremental voltage.

**Patentansprüche**

1. Vorrichtung, umfassend:
   ein Verarbeitungssystem (1891), konfiguriert zum:

   Bestimmen von Konfigurationsdaten (1901);
   Bestimmen, unter Verwendung der Konfigurationsdaten, eines Widerstands eines Stromkabels (1903), das eine programmierbare Stromversorgung mit einem Remote Radio Head koppelt, der an einer Befestigungsstruktur angebracht ist, umfassend:

Bestimmen einer anfänglichen Schätzung des Widerstands des Stromkabels (2101);

Bestimmen einer gewünschten Remote-Radio-Head-Spannung (2103);

Bestimmen einer anfänglichen Ausgangsspannung der programmierbaren Stromversorgung (2105);

Einstellen einer Ausgangsspannung der programmierbaren Stromversorgung (2107);

Empfangen einer gemessenen Remote-Radio-Head-Spannung;

Bestimmen, ob ein Absolutwert einer Differenz zwischen der gemessenen Remote-Radio-Head-Spannung und der gewünschten Remote-Radio-Head-Spannung kleiner als eine Schwellenspannung ist (2115);

wenn der Absolutwert der Differenz zwischen der gemessenen Remote-Radio-Head-Spannung und der gewünschten Remote-Radio-Head-Spannung nicht kleiner als die Schwellenspannung ist, dann Bestimmen, ob die gemessene Remote-Radio-Head-Spannung größer als die gewünschte Remote-Radio-Head-Spannung ist (2117);

wenn die gemessene Remote-Radio-Head-Spannung größer als die gewünschte Remote-Radio-Head-Spannung ist, dann Verringern einer Schätzung des Widerstands des Stromkabels (2119);

wenn die gemessene Remote-Radio-Head-Spannung nicht größer als die gewünschte Remote-Radio-Head-Spannung ist, dann Erhöhen der Schätzung des Widerstands des Stromkabels (2123);

Bestimmen einer neuen Ausgangsspannung der programmierbaren Stromversorgung (2121); und Speichern einer neuen Schätzung des Widerstands des Stromkabels (1905).

2. Vorrichtung nach Anspruch 1, wobei das Verarbeitungssystem ferner so konfiguriert ist, dass es bestimmt, ob der Widerstand des Stromkabels erneut bestimmt werden soll (1907).

3. Vorrichtung nach Anspruch 2, wobei das Bestimmen, ob der Widerstand des Stromkabels erneut bestimmt werden soll, ein Bestimmen, ob der Widerstand des Stromkabels erneut bestimmt werden soll, basierend auf mindestens einem der Folgenden umfasst:
Deaktivierung des Remote Radio Head, Verstreichen eines festen Zeitraums, Wetteränderungen und Remote-Radio-Head-Detektion eines Überspannungs- oder Unterspannungszustands.

4. Vorrichtung nach Anspruch 1, wobei das Erhöhen der Schätzung des Widerstands ein Erhöhen der Schätzung des Widerstands um einen Inkrementalwiderstand umfasst; und wobei das Verringern der Schätzung des Widerstands ein Verringern der Schätzung des Widerstands um den Inkrementalwiderstand umfasst.

5. Vorrichtung nach Anspruch 1, wobei das Verarbeitungssystem ferner konfiguriert ist zum: Empfangen einer Messung eines Ausgangsstroms der programmierbaren Stromversorgung; Bestimmen, ob der Ausgangsstrom größer als null Ampere ist; und
bei Bestimmen, dass der Ausgangsstrom nicht größer als null Ampere ist, dann Erhöhen der Ausgangsspannung.

6. Vorrichtung nach Anspruch 5, wobei das Erhöhen der Ausgangsspannung ein Erhöhen der Ausgangsspannung um eine Inkrementalspannung umfasst.

7. Vorrichtung nach Anspruch 1, wobei das Bestimmen der Konfigurationsdaten ein Erhalten, aus einer Datenbank, von mindestens einem der Folgenden umfasst: der anfänglichen Schätzung des Widerstands, der gewünschten Remote-Radio-Head-Spannung, der anfänglichen Ausgangsspannung der programmierbaren Stromversorgung, einem Inkrementalwiderstand und einer Inkrementalspannung.

8. Verfahren, umfassend:

Bestimmen von Konfigurationsdaten;

Bestimmen, unter Verwendung der Konfigurationsdaten, eines Widerstands eines Stromkabels (1903), das eine programmierbare Stromversorgung (28, 1627, 1727) mit einem Remote Radio Head (24') koppelt, der an einer Befestigungsstruktur angebracht ist, umfassend:

Bestimmen einer anfänglichen Schätzung des Widerstands des Stromkabels (2101);

Bestimmen einer gewünschten Remote-Radio-Head-Spannung (2103);

Bestimmen einer anfänglichen Ausgangsspannung der programmierbaren Stromversorgung (2105);

Einstellen einer Ausgangsspannung der programmierbaren Stromversorgung (2107);

Empfangen einer gemessenen Remote-Radio-Head-Spannung;

Bestimmen, ob ein Absolutwert einer Differenz zwischen der gemessenen Remote-Radio-Head-Spannung und der gewünschten Remote-Radio-Head-Spannung kleiner als eine Schwellenspannung ist (2115);
wenn der Absolutwert der Differenz zwischen der gemessenen Remote-Radio-Head-Spannung und der gewünschten Remote-Radio-Head-Spannung nicht kleiner als die Schwellenspannung ist, dann Bestimmen, ob die gemessene Remote-Radio-Head-Spannung größer als die gewünschte Remote-Radio-Head-Spannung ist (2117);
wenn die gemessene Remote-Radio-Head-Spannung größer als die gewünschte Remote-Radio-Head-Spannung ist, dann Verringern einer Schätzung des Widerstands des Stromkabels (2119);
wenn die gemessene Remote-Radio-Head-Spannung nicht größer als die gewünschte Remote-Radio-Head-Spannung ist, dann Erhöhen der Schätzung des Widerstands des Stromkabels (2123);
Bestimmen einer neuen Ausgangsspannung der programmierbaren Stromversorgung (2121); und Speichern einer neuen Schätzung des Widerstands des Stromkabels (1905).

9. Verfahren nach Anspruch 8, ferner umfassend: Bestimmen, ob der Widerstand des Stromkabels (1907) erneut bestimmt werden soll.

10. Verfahren nach Anspruch 9, wobei das Bestimmen, ob der Widerstand des Stromkabels erneut bestimmt werden soll, ein Bestimmen, ob der Widerstand des Stromkabels erneut bestimmt werden soll, basierend auf mindestens einem der Folgenden umfasst: Deaktivierung des Remote Radio Head, Verstreichen eines festen Zeitraums, Wetteränderungen und Remote-Radio-Head-Detektion einer Überspannungs- oder Unterspannungsbedingung.

11. Verfahren nach Anspruch 8, wobei das Erhöhen der Schätzung des Widerstands ein Erhöhen der Schätzung des Widerstands um einen Inkrementalwiderstand umfasst; und wobei das Verringern der Schätzung des Widerstands ein Verringern der Schätzung des Widerstands um den Inkrementalwiderstand umfasst.

12. Verfahren nach Anspruch 8, ferner umfassend:

Messen eines Ausgangsstroms der programmierbaren Stromversorgung;
Bestimmen, ob der Ausgangsstrom größer als null Ampere ist; und
wenn der Ausgangsstrom nicht größer als null Ampere ist, dann Erhöhen der Ausgangsspannung.

13. Verfahren nach Anspruch 12, wobei das Erhöhen der Ausgangsspannung ein Erhöhen der Ausgangsspannung um eine Inkrementalspannung umfasst.

14. Verfahren nach Anspruch 11, wobei das Bestimmen der Konfigurationsdaten ein Erhalten, aus einer Datenbank, von mindestens einem der Folgenden umfasst: der anfänglichen Schätzung des Widerstands, der gewünschten Remote-Radio-Head-Spannung, der anfänglichen Ausgangsspannung der programmierbaren Stromversorgung, dem Inkrementalwiderstand und einer Inkrementalspannung.

**Revendications**

1. Appareil, comprenant :
un système de traitement (1891) configuré pour :

déterminer des données de configuration (1901) ;
à l'aide des données de configuration, déterminer une résistance d'un câble de puissance (1903) couplant une alimentation programmable à une tête radio déportée montée sur une structure de montage, comprenant :

la détermination d'une estimation initiale de la résistance du câble de puissance (2101) ;
la détermination d'une tension de tête radio déportée (2103) souhaitée ;
la détermination d'une tension de sortie initiale de l'alimentation programmable (2105) ;
établir une tension de sortie de l'alimentation programmable (2107) ;
recevoir une tension de tête radio déportée mesurée ;
déterminer si une valeur absolue d'une différence entre la tension de tête radio déportée mesurée et la tension de tête radio déportée souhaitée est inférieure à une tension seuil (2115) ;
si la valeur absolue de la différence entre la tension de tête radio déportée mesurée et la tension de tête radio déportée souhaitée n'est pas inférieure à la tension seuil, alors déterminer si la tension de tête radio déportée mesurée est supérieure à la tension de tête radio déportée souhaitée (2117) ;
si la tension de tête radio déportée mesurée est supérieure à la tension de tête radio déportée souhaitée, alors diminuer une estimation de la résistance du câble de puissance (2119) ;
si la tension de tête radio déportée mesurée n'est pas supérieure à la tension de tête radio déportée souhaitée, alors augmenter l'estimation de la résistance du câble de puissance (2123) ;
déterminer une nouvelle tension de sortie de l'alimentation programmable (2121) ; et stocker une nouvelle estimation de la résistance du câble de puissance (1905).

**2.** Appareil selon la revendication 1, dans lequel le système de traitement est en outre configuré pour déterminer s'il faut à nouveau déterminer la résistance du câble de puissance (1907).

**3.** Appareil selon la revendication 2, dans lequel le fait de déterminer s'il faut à nouveau déterminer la résistance du câble de puissance comprend le fait de déterminer s'il faut à nouveau déterminer la résistance du câble de puissance sur la base d'au moins l'un parmi :
une désactivation de la tête radio déportée, l'écoulement d'une période fixe, des changements météorologiques, et une détection de tête radio déportée d'une condition de surtension ou de sous-tension.

**4.** Appareil selon la revendication 1, dans lequel l'augmentation de l'estimation de la résistance comprend l'augmentation de l'estimation de la résistance d'une résistance incrémentielle ; et dans lequel la diminution de l'estimation de la résistance comprend la diminution de l'estimation de la résistance de la résistance incrémentielle.

**5.** Appareil selon la revendication 1, dans lequel le système de traitement est en outre configuré pour :

recevoir une mesure d'un courant de sortie de l'alimentation programmable ;
déterminer si le courant de sortie est supérieur à zéro ampère ; et
lorsqu'il est déterminé que le courant de sortie n'est pas supérieur à zéro ampère, alors augmenter la tension de sortie.

**6.** Appareil selon la revendication 5, dans lequel l'augmentation de la tension de sortie comprend l'augmentation de la tension de sortie d'une tension incrémentielle.

**7.** Appareil selon la revendication 1, dans lequel la détermination des données de configuration comprend l'obtention, à partir d'une base de données, d'au moins l'une parmi : l'estimation initiale de la résistance, la tension de tête radio déportée souhaitée, la tension de sortie initiale de l'alimentation programmable, une résistance incrémentielle et une tension incrémentielle.

**8.** Procédé, comprenant :

la détermination de données de configuration ;
à l'aide des données de configuration, la détermination d'une résistance d'un câble de puissance (1903) couplant une alimentation programmable (28, 1627, 1727) à une tête radio déportée (24') montée sur une structure de montage, comprenant :

la détermination d'une estimation initiale de la résistance du câble de puissance (2101) ;
la détermination d'une tension de tête radio déportée souhaitée (2103) ;
la détermination d'une tension de sortie initiale de l'alimentation programmable (2105) ;
l'établissement d'une tension de sortie de l'alimentation programmable (2107) ;
la réception d'une tension de tête radio déportée mesurée ;
la détermination du fait qu'une valeur absolue d'une différence entre la tension de tête radio déportée mesurée et la tension de tête radio déportée souhaitée est inférieure à une tension seuil (2115) ;
si la valeur absolue de la différence entre la tension de tête radio déportée mesurée et la tension de tête radio déportée souhaitée n'est pas inférieure à la tension seuil, alors la détermination du fait que la tension de tête radio déportée mesurée est supérieure à la tension de tête radio déportée souhaitée (2117) ;
si la tension de tête radio déportée mesurée est supérieure à la tension de tête radio déportée souhaitée, alors la diminution d'une estimation de la résistance du câble de puissance (2119) ;
si la tension de tête radio déportée mesurée n'est pas supérieure à la tension de tête radio déportée souhaitée, alors l'augmentation de l'estimation de la résistance du câble de puissance (2123) ;
la détermination d'une nouvelle tension de sortie de l'alimentation programmable (2121) ; et le stockage d'une nouvelle estimation de la résistance du câble de puissance (1905).

9. Procédé selon la revendication 8, comprenant en outre : le fait de déterminer s'il faut à nouveau déterminer la résistance du câble de puissance (1907).

10. Procédé selon la revendication 9, dans lequel le fait de déterminer s'il faut à nouveau déterminer la résistance du câble de puissance comprend le fait de déterminer s'il faut à nouveau déterminer la résistance du câble de puissance sur la base d'au moins l'un parmi : une désactivation de la tête radio déportée, l'écoulement d'une période fixe, des changements météorologiques et une détection de tête radio déportée d'une condition de surtension ou de sous-tension.

11. Procédé selon la revendication 8, dans lequel l'augmentation de l'estimation de la résistance comprend l'augmentation de l'estimation de la résistance d'une résistance incrémentielle ; et dans lequel la diminution de l'estimation de la résistance comprend la diminution de l'estimation de la résistance de la résistance incrémentielle.

12. Procédé selon la revendication 8, comprenant en outre :

la mesure d'un courant de sortie de l'alimentation programmable ;
le fait de déterminer si le courant de sortie est supérieur à zéro ampère ; et
si le courant de sortie n'est pas supérieur à zéro ampère, alors l'augmentation de la tension de sortie.

13. Procédé selon la revendication 12, dans lequel l'augmentation de la tension de sortie comprend l'augmentation de la tension de sortie d'une tension incrémentielle.

14. Procédé selon la revendication 11, dans lequel la détermination des données de configuration comprend l'obtention, à partir d'une base de données, d'au moins l'une parmi : l'estimation initiale de la résistance, la tension de tête radio déportée souhaitée, la tension de sortie initiale de l'alimentation programmable, la résistance incrémentielle et une tension incrémentielle.

Cellular Base
Station
10

Backhaul
Communication
System
44

Radio
24

Power Supply
26

32-1

32-3

32-2

34

30

Enclosure
20

Baseband Unit
22

## FIG. 1
## (Prior Art)

Cellular Base
Station
10'

Backhaul
Communication
System
44

32-1

32-3

RRH
24'

32-2

Power Supply
26

40

30

38

36

Enclosure
20

Baseband Unit
22

## FIG. 2
## (Prior Art)

**FIG. 3**

**FIG. 4**

**FIG. 5**

**FIG. 6**

**FIG. 7**

**FIG. 8**

```
┌─────────────────┐     ┌─────────────────┐     ┌─────────────────┐
│  Input Cable    │     │ Output DC Power │     │ Measure Current │
│  Resistance     │────▶│     Signal      │────▶│ of              │
│  Information    │     │      310        │     │ DC Power Signal │
│     300         │     │                 │     │      320        │
└─────────────────┘     └─────────────────┘     └─────────────────┘
         │                                                │
         │              ┌─────────────────┐               │
         │              │ Adjust Output   │               │
         └─────────────▶│ Signal Voltage  │◀──────────────┘
                        │ Based on I and R│
                        │      330        │
                        └─────────────────┘
```

*FIG. 9*

*FIG. 10*

**FIG. 11**

**FIG. 12**

**FIG. 13**

Power Supply

Remote Radio Head

**FIG. 14**

Cellular Base Station 700

1st Power Supply 26

2nd Power Supply 28

RRH 1 724

RRH 2 724

RRH 11 724

RRH 12 724

**FIG. 15**

**FIG. 16**

**FIG. 17A**

Communication Link 1761

Enclosure 1720

Clock 1 1745

External Processing System 1729

Transceiver 1725

Programmable Power Supply 1727

Baseband Unit 1722

1736

1738

1736/1738

Backhaul Communications System 1744

Cellular Base Station 1700

1732-1

1732-2

1732-3

1736

BP 1749

RRH 1724

1738

Control Module 1750

1730

EP 3 580 631 B1

## FIG. 17B

**FIG. 17C**

Memory  1893

Power Supply
Voltage(s) Database
1841

Power Cable
Resistance(s)
Database
1847

Power Supply
Current(s) Database
1843

Resistance
Calculation System
1849

RRH Voltage(s)
Database
1845

Configuration
Database
1851

Processor
1895

Processing System 1891

## FIG. 18

**FIG. 19**

2021

2001 — Set Output Voltage

2003 — Measure Output Voltage(s) and Output Current(s)

2005 — Store Output Voltage(s) and Output Current(s)

2007 — Measure Remote Radio Head Voltage(s)

2009 — Store Remote Radio Head Voltage(s)

2011 — Align Waveforms of Measured Data

2013 — Determine Difference Voltage(s)

2015 — Determine Resistance(s)

2017 — Remove Outlier(s)

2019 — Determine Resistance of Power Cable

*FIG. 20*

FIG. 21A

2131

2133
N ≥ M?   Yes →   2135   Issue Alarm

No

2137
Measured Current > Threshold Current?   Yes →   To Block 2113

No

2139
Increase Number of Increments

↓

To Block 2112

*FIG. 21B*

2211

```
2201 ──┐  ┌─────────────────────────────┐
         │      Enter Calibration Mode      │
         └─────────────────────────────┘
                        │
                        ▼
2203 ──┐  ┌─────────────────────────────┐
         │         Set Output Voltage       │
         └─────────────────────────────┘
                        │
                        ▼
2205 ──┐  ┌─────────────────────────────┐
         │      Measure Output Current     │
         └─────────────────────────────┘
                        │
                        ▼
2207 ──┐  ┌─────────────────────────────┐
         │        Store Output Current     │
         └─────────────────────────────┘
                        │
                        ▼
2209 ──┐  ┌─────────────────────────────┐
         │    Determine Cable Resistance   │
         └─────────────────────────────┘
```

# FIG. 22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62456428
- US 70190415
- US 32189714
- US 61940631
- US 2015234399 A1
- US 2012317426 A1

- US 2015015078 A1
- US 2006164108 A1
- US 6813510 B1
- US 4745562 A
- US 20150080055

**Non-patent literature cited in the description**

- **MCGILL et al.** High-Resolution Alignment of Sampled Waveforms. *IEEE Transactions on Biomedical Engineering,* June 1984, vol. BME-31 (6), 462-468